# EUROPEAN PATENT APPLICATION

(11) **EP 4 826 119 A1**
(43) Date of publication of application: **21.10.2026**
(21) Application number: 24903703.7
(22) Date of filing: 11.12.2024
(51) Int. Cl.: C23C 16/511, C23C 16/40, C23C 16/448, H01L 21/205, H01L 21/368

(54) **FILM FORMING DEVICE, FILM FORMING METHOD, CRYSTALLINE METAL OXIDE FILM, AND LAMINATED STRUCTURE AND SEMICONDUCTOR DEVICE USING SAME**

(30) Priority: 15.12.2023 JP 2023212096
(71) Applicant: SHIN-ETSU CHEMICAL CO., LTD., Tokyo 100-0005 (JP)
(72) Inventor: SAKATSUME Takahiro, Annaka-shi, Gunma 379-0195 (JP)
(74) Representative: Schicker, Silvia
(86) International application number: PCT/JP2024/043723
(87) International publication number: WO 2025/127049

(57) **Abstract**

The present invention is a film forming apparatus including: a misting unit that mists a raw material solution to generate mist; a carrier gas supply unit that supplies a carrier gas for transporting the mist; a film forming unit that subjects the mist to heat treatment and forms a film on a base body; a transport unit that connects the misting unit with an inside of the film forming unit, the transport unit including a supply pipe that transports the mist by the carrier gas; and a microwave heating device that irradiates the mist with microwaves to heat the mist, between the misting unit and the base body. Thereby, a film forming apparatus is provided that can form a film having high crystallinity, on a large-diameter substrate at a high film forming rate, while inhibiting foreign substances and abnormal growth.

## Description

### TECHNICAL FIELD

The present invention relates to a film forming apparatus and a film forming method, a crystalline metal oxide film, and a layered structure and a semiconductor device using the crystalline metal oxide film.

### BACKGROUND ART

Conventionally, a high-vacuum film forming apparatus which can realize a non-equilibrium state has been developed, such as a pulsed laser deposition (pulsed laser deposition: PLD) method, a molecular beam epitaxy (molecular beam epitaxy: MBE) method, or a sputtering method, and it has become possible to produce an oxide semiconductor which has been impossible to be produced by a melt method or the like.

In addition, a mist chemical vapor deposition method (Mist Chemical Vapor Deposition: Mist CVD which will be hereinafter referred to also as "mist CVD method") has been developed in which a crystal is grown on a substrate with the use of a raw material atomized to a misty state; and it has become possible to produce gallium oxide having a corundum structure (α-Ga₂O₃). The α-Ga₂O₃ is expected to be applied to a next-generation switching element which can realize high withstand voltage, low losses and high heat resistance, as a semiconductor having a large band gap.

Regarding the mist CVD method, Patent Document 1 describes a tubular furnace type of mist CVD apparatus. Patent Document 2 describes a fine channel type of mist CVD apparatus. Patent Document 3 describes a linear source type of mist CVD apparatus. Patent Document 4 describes a mist CVD apparatus of a tubular furnace, which is different from the mist CVD apparatus described in Patent Document 1 in that a carrier gas is introduced into a mist generator. Patent Document 5 describes a mist CVD apparatus in which a substrate is placed above a mist generator, and further, a susceptor is a rotating stage provided on a hot plate.

### CITATION LIST

### PATENT LITERATURE

Patent Document 1: JP H01-257337A
Patent Document 2: JP 2005-307238A
Patent Document 3: JP 2012-046772A
Patent Document 4: JP 5397794B
Patent Document 5: JP 2014-063973A
Patent Document 6: JP 7080115B
Patent Document 7: JP 6875336B
Patent Document 8: JP 7239919B

### SUMMARY OF INVENTION

### TECHNICAL PROBLEM

Unlike other CVD methods, a mist CVD method can form a film at a relatively low temperature, and can produce a metastable phase of crystalline structure such as a corundum structure of α-Ga₂O₃. However, the present inventor has found a problem that, in the conventional mist CVD method, the generated mist is condensed and coagulates in the supply pipe to form dew (decrease in the life of the mist) until the mist is transported to the substrate, and the dew formed from the mist is not sent to the film forming unit, resulting in a decrease in a film forming rate.

In addition, the present inventor has further found problems that when a large amount of mist is supplied to a substrate, when a film is formed on a base body having a large diameter in order to improve productivity, a temperature of the film-forming surface of the substrate is rapidly lowered due to the low temperature of the mist, and that a decrease in crystallinity of the film and a damage to the substrate occur.

Regarding the production of α-Ga₂O₃ by the mist CVD method, Patent document 6 reports an example in which a pipe for transporting mist is heated by a heater to extend the life of the mist and improve a film forming rate. In addition, as a similar attempt, Patent Document 7 reports an example in which a carrier gas for transporting mist is heated, thereby the life of mist is extended, and the film forming rate has been improved.

However, in the methods described in Patent Document 6 and Patent Document 7, as the temperature of the gas becomes higher, the saturated water vapor pressure increases, and accordingly, evaporation of the mist is promoted. As a result, such a problem occurs that not only the mist to be supplied to the substrate is reduced, but also the raw material in the mist is deposited and adheres to the film as a foreign substance, which causes abnormal growth.

Furthermore, such a problem occurs that when a semiconductor device is manufactured with the use of a film containing a large number of such foreign substances, the foreign substances become killer defects, and the withstand voltage is lowered. In particular, when the foreign substance is large, the killer defect tends to easily occur. These foreign substances, which are generated during the film formation, cause abnormal growth when having been embedded in or attached to the film during the film formation, and accordingly, it is desirable to suppress the generation of the foreign substances in the film forming step.

In addition, in Patent Document 8, as a method of suppressing evaporation of mist, an example is reported in which a film forming rate has been improved by causing a carrier gas for transporting mist to contain moisture and thereby increasing relative humidity. However, in this method, the temperature of the film-forming surface of the substrate is lowered by the moisture in the carrier gas, and accordingly, the crystallinity of the film is lowered or the substrate is damaged; and this method could not be used as a method for forming a film on a large-diameter substrate at a high film forming rate.

The present invention has been made to solve the above problems, and the object is to provide: a film forming apparatus and a film forming method that can form a film having high crystallinity at a high film forming rate on a large-diameter substrate while inhibiting foreign substances and abnormal growth; and a crystalline metal oxide film in which the foreign substances are inhibited.

### SOLUTION TO PROBLEM

The present invention has been made to achieve the above object, and provides a film forming apparatus comprising: a misting unit that mists a raw material solution to generate mist; a carrier gas supply unit that supplies a carrier gas for transporting the mist; a film forming unit that subjects the mist to heat treatment and forms a film on a base body; a transport unit that connects the misting unit with an inside of the film forming unit, the transport unit including a supply pipe that transports the mist by the carrier gas; and a microwave heating device that irradiates the mist with microwaves to heat the mist, between the misting unit and the base body.

According to such a film forming apparatus, it is possible to heat selectively and rapidly only the mist among the mist and the carrier gas supplied to the base body, thereby suppressing the evaporation of the mist without increasing a saturated water vapor pressure of the carrier gas. Because of this, it is possible to enhance the film forming rate while inhibiting foreign substances and abnormal growth. Furthermore, it is possible to supply the mist of high temperature to the base body, and accordingly, the temperature drop of the base body is suppressed even if the supply amount of the mist is increased; and it becomes possible to form the film at a high film forming rate without damaging the crystallinity even on the base body having a large diameter.

At this time, it is possible that the microwave heating device comprises a microwave generation unit; a microwave irradiation unit that irradiates the mist with microwaves generated in the microwave generation unit; and a microwave waveguide unit through which the microwaves propagate from the microwave generation unit to the microwave irradiation unit.

Thereby, it becomes possible to stably irradiate the mist with the microwaves.

At this time, it is possible that a portion of the supply pipe arranged in the microwave irradiation unit is formed of a microwave-transmissive member.

Thereby, the microwaves directly reach the mist in the inside, and the mist can be directly heated by the microwaves.

At this time, it is possible that the portion of the supply pipe arranged in the microwave irradiation unit is formed of any one of quartz, ceramic, alumina, a polytetrafluoroethylene resin, a copolymer resin of tetrafluoroethylene and perfluoroalkyl vinyl ether, a copolymer resin of tetrafluoroethylene and hexafluoropropylene, and a polyether ether ketone resin.

Thereby, unintended contamination from a microwave irradiation portion of the supply pipe can be effectively suppressed.

In order to achieve the above object, the present invention also provides a film forming method comprising the steps of: generating mist by atomizing or dropletizing a raw material solution; transporting the mist to a film forming unit by a carrier gas; heating the mist with microwaves before the mist reaches a base body installed in the film forming unit; and forming a film on the base body by supplying the mist to the base body in the film forming unit, and subjecting the mist to heat treatment on the base body.

According to such a film forming method, it is possible to heat selectively and rapidly only the mist among the mist and the carrier gas supplied to the base body, thereby suppressing the evaporation of the mist without increasing a saturated water vapor pressure of the carrier gas. Because of this, it is possible to enhance the film forming rate while inhibiting foreign substances and abnormal growth. Furthermore, it is possible to supply the mist of high temperature to the base body, and accordingly, the temperature drop of the base body is suppressed even if the supply amount of the mist is increased; and it becomes possible to form the film at a high film forming rate without damaging the crystallinity even on the base body having a large diameter.

At this time, the raw material solution can contain a metal raw material, and at least one solvent selected from water, methanol, ethanol, ethylene glycol, diethylene glycol, propylene glycol, tetraethylene glycol, glycerol, benzyl alcohol, and dipropylene glycol.

Thereby, it is possible to selectively and rapidly heat the mist by microwave heating.

At this time, it is possible that, as the solvent of the raw material solution, a solvent containing water as a main component is used.

Thereby, it becomes difficult for impurities derived from the solvent to remain in the film, and atomization efficiency becomes excellent; and it becomes advantageous also in terms of cost.

At this time, it is possible that, as the metal raw material, a material containing Ga is used.

Thereby, an α-Ga₂O₃ film can be stably produced.

At this time, it is possible that, as the base body, a base body having a film-forming surface with a diameter of 10 cm (4 inches) or larger is used.

When the base body is set to have a large diameter in this way, the crystalline metal oxide film formed on the base body can be formed to have further higher quality and higher productivity.

At this time, it is possible that a frequency of the microwaves is set to 0.9 GHz or higher and 300 GHz or lower.

Thereby, it is possible to stably heat the mist, and to uniformly heat even the inside of the mist because of keeping a penetration depth of the microwaves to an appropriate length.

At this time, it is possible that the frequency of the microwaves is set to 2.45 GHz or higher and 25 GHz or lower.

Thereby, it is possible to more stably heat the mist, and to more uniformly heat even the inside of the mist because of keeping a penetration depth of the microwaves to an appropriate length.

The present invention has been made to achieve the above object, and provides a crystalline metal oxide film comprising at least one of gallium or aluminum as a main component, wherein the number density of foreign substances observed in a surface direction of the crystalline metal oxide film is less than 48/cm², and a standard deviation in a particle size distribution of the foreign substances is smaller than 1.25 µm.

It is possible to suitably use such a crystalline metal oxide film for a semiconductor device, because the film contains few foreign substances and accordingly has satisfactory smoothness, and the size of the foreign substance is small and uniform; and accordingly, when a semiconductor device is manufactured with the use of the crystalline metal oxide film, an influence of the foreign substances on device characteristics becomes minor.

At this time, it is possible that, in the particle size distribution of the foreign substances, an index of the particle size distribution (particle size D90 / particle size D10) is 4.0 or smaller.

In such a crystalline metal oxide film, as the size of the foreign substance is more uniform, the design of the semiconductor device becomes easier, and accordingly, the crystalline metal oxide film can be suitably used for the semiconductor device.

At this time, it is possible that a ratio of particles having a particle size of (particle size D50 - the standard deviation) or larger and (particle size D50 + the standard deviation) or smaller, to a total number of the foreign substances, among the foreign substances, is 60% or larger.

In such a crystalline metal oxide film, as the size of the foreign substance is more uniform, the design of the semiconductor device becomes easier, and accordingly, the crystalline metal oxide film can be suitably used for the semiconductor device.

At this time, it is possible that a particle size D50 of the foreign substances is smaller than 2.75 µm.

Such a crystalline metal oxide film can be suitably used for a semiconductor device, because the foreign substance is small, and when the semiconductor device has been manufactured with the use of the crystalline metal oxide film, the influence of the foreign substance on the device characteristics becomes further minor.

At this time, it is possible that a particle size D90 of the foreign substances is smaller than 4.25 µm.

Such a crystalline metal oxide film can be suitably used for a semiconductor device, because the foreign substance is small, and when the semiconductor device has been manufactured with the use of the crystalline metal oxide film, the influence of the foreign substance on the device characteristics becomes further minor.

At this time, it is possible that the crystalline metal oxide film has a corundum structure.

Such a crystalline metal oxide film becomes a crystalline metal oxide film that has a corundum structure with more satisfactory smoothness.

At this time, it is possible that a half width of a rocking curve of a (006) plane by X-ray diffraction of the crystalline metal oxide film is smaller than 19.1 s.

It becomes possible to suitably use such a crystalline metal oxide film for a semiconductor device because the film has more satisfactory crystallinity.

At this time, it is possible that a diameter of a surface of the crystalline metal oxide film is 10 cm (4 inches) or larger.

It becomes possible to further suitably use such a crystalline metal oxide film for a semiconductor device because the film has more satisfactory smoothness and has a large area.

At this time, it is possible to provide a layered structure comprising: a base body, a buffer layer on the base body, and the above crystalline metal oxide film on the buffer layer.

It becomes possible to suitably use such a layered structure for a semiconductor device because the crystalline metal oxide film has satisfactory smoothness.

At this time, it is possible to provide a semiconductor device comprising the above crystalline metal oxide film and/or the above layered structure.

Such a semiconductor device becomes a semiconductor device having satisfactory electrical characteristics because the crystalline metal oxide film is excellent in smoothness.

At this time, it is possible that the semiconductor device is any one of a semiconductor laser, a diode, or a transistor.

Such a semiconductor device becomes a semiconductor laser, a diode, or a transistor that is excellent in electrical characteristics.

### ADVANTAGEOUS EFFECTS OF INVENTION

As in the above, according to the film forming apparatus of the present invention, it becomes possible to form a film that has high crystallinity on a large-diameter substrate at a high film forming rate while inhibiting foreign substances and abnormal growth, in the mist CVD method. In addition, according to the film forming method of the present invention, it becomes possible to form a film that has high crystallinity on a large-diameter substrate at a high film forming rate while inhibiting foreign substances and abnormal growth, in the mist CVD method.

In addition, it becomes possible to suitably use the crystalline metal oxide film of the present invention for a semiconductor device, because the film contains few foreign substances and accordingly has satisfactory smoothness, and the size of the foreign substance is small and uniform, and accordingly when a semiconductor device is manufactured with the use of the crystalline metal oxide film, an influence of the foreign substances on device characteristics becomes minor. The present invention further provides a layered structure and a semiconductor device that have the crystalline metal oxide film having such features.

### BRIEF DESCRIPTION OF DRAWINGS

[FIG. 1] is a schematic view showing an example of a film forming apparatus according to the present invention;
[FIG. 2] is a schematic view showing an example of a misting unit according to the present invention;
[FIG. 3] is a schematic view showing an example of a microwave heating device according to the present invention;
[FIG. 4] is a schematic view showing an example of an applicator according to the present invention ((a) perspective view, and (b) side sectional view);
[FIG. 5] is a graph showing (a) a distribution of an electric field intensity ratio in a long axis direction of a waveguide and (b) the electric field intensity in the traveling direction of an applicator, in the case in which the microwaves of 2.45 GHz have been used;
[FIG. 6] is a view showing an example of a foreign substance found in a film produced in Comparative Example;
[FIG. 7] is a view showing an example of an abnormal growth portion observed in a film produced in Comparative Example;
[FIG. 8] is an electron diffraction image of the outside of the abnormal growth portion in FIG. 7;
[FIG. 9] is an electron diffraction image of a crystal portion observed at the center of the abnormal growth portion in FIG. 7;
[FIG. 10] is a diagram showing a particle size distribution of foreign substances observed in the films produced in Example 1 and Comparative Example 1;
[FIG. 11] is a diagram showing evaluation results of the yield of the films produced in Example 1 and Comparative Example 1;
[FIG. 12] is a schematic cross-sectional view showing an embodiment of the structure of a layered structure according to the present invention;
[FIG. 13] is a schematic cross-sectional view showing an example of a Schottky barrier diode according to the present invention;
[FIG. 14] is a schematic cross-sectional view showing an example of a high electron mobility transistor according to the present invention;
[FIG. 15] is a schematic cross-sectional view showing an example of a semiconductor field-effect transistor according to the present invention;
[FIG. 16] is a schematic cross-sectional view showing an example of an insulated gate type bipolar transistor according to the present invention; and
[FIG. 17] is a schematic cross-sectional view showing an example of a light-emitting element diode according to the present invention.

### DESCRIPTION OF EMBODIMENTS

The present invention will be described in detail below, but the present invention is not limited thereto.

As described above, there has been a demand for a film forming apparatus and a film forming method that can form a film having high crystallinity at a high film forming rate on a large-diameter substrate while inhibiting foreign substances and abnormal growth, and for a crystalline metal oxide film in which the foreign substances are inhibited.

As a result of intensive studies on the above problems, the present inventor has completed the present invention by finding that, by a film forming apparatus including: a misting unit that mists a raw material solution to generate mist; a carrier gas supply unit that supplies a carrier gas for transporting the mist; a film forming unit that subjects the mist to heat treatment and forms a film on a base body; a transport unit that connects the misting unit with an inside of the film forming unit, the transport unit including a supply pipe that transports the mist by the carrier gas; and a microwave heating device that irradiates the mist with microwaves to heat the mist, between the misting unit and the base body, it is possible to heat selectively and rapidly only the mist among the mist and the carrier gas to be supplied to the base body, thereby suppressing the evaporation of the mist without increasing a saturated water vapor pressure of the carrier gas; thus, it is possible to enhance the film forming rate while inhibiting foreign substances and abnormal growth; and furthermore, it is possible to supply the mist of high temperature to the base body, and accordingly, the temperature drop of the base body is suppressed even when the supply amount of the mist is increased, and it becomes possible to form the film at a high film forming rate without damaging the crystallinity even on the base body having a large diameter.

The present inventor has completed the present invention also by finding that, by a film forming method including the steps of: generating mist by atomizing or dropletizing a raw material solution; transporting the mist to a film forming unit by a carrier gas; heating the mist with microwaves before the mist reaches a base body installed in the film forming unit; and forming a film on the base body by supplying the mist to the base body in the film forming unit, and subjecting the mist to heat treatment on the base body, it is possible to heat selectively and rapidly only the mist among the mist and the carrier gas to be supplied to the base body, thereby suppressing the evaporation of the mist without increasing a saturated water vapor pressure of the carrier gas; thus, it is possible to enhance the film forming rate while inhibiting foreign substances and abnormal growth; and furthermore, it is possible to supply the mist of high temperature to the base body, and accordingly, the temperature drop of the base body is suppressed even when the supply amount of the mist is increased, and it becomes possible to form the film at a high film forming rate without damaging the crystallinity even on the base body having a large diameter.

The present inventor has completed the present invention by further finding that, by a crystalline metal oxide film including at least one of gallium or aluminum as a main component, in which the number density of foreign substances observed in a surface direction of the crystalline metal oxide film is less than 48/cm², and a standard deviation in a particle size distribution of the foreign substances is smaller than 1.25 µm, the influence of the foreign substances on the device characteristics becomes minor, and the film can be suitably used for a semiconductor device when the semiconductor device is manufactured with the use of the crystalline metal oxide film, because the film has satisfactory smoothness due to a small amount of foreign substances and the foreign substances have small and uniform sizes.

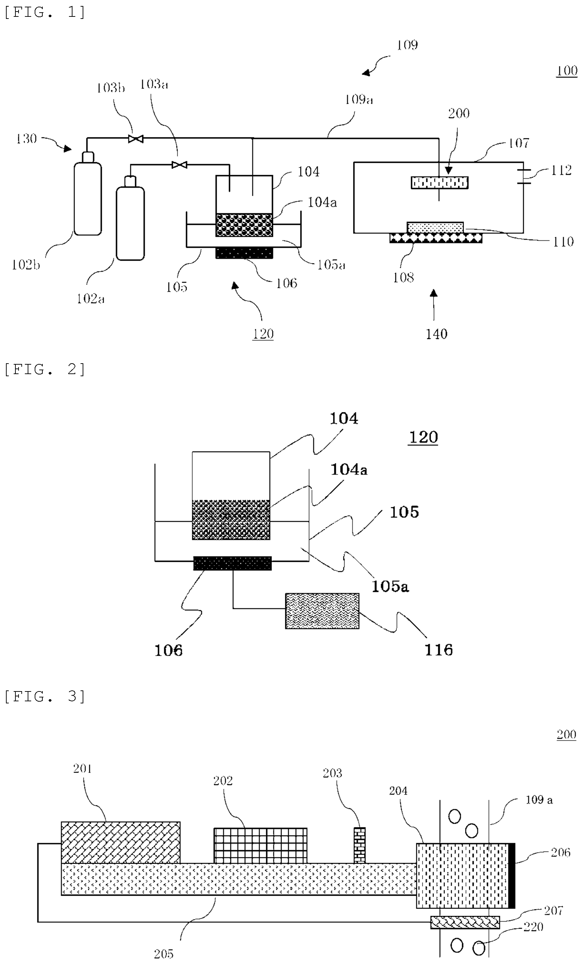

The film forming apparatus of the present invention will be described below with reference to FIGS. 1 to 5.

### (Film forming apparatus)

FIG. 1 shows an example of a film forming apparatus of the present invention. As shown in FIG. 1, a film forming apparatus 100 includes: a misting unit 120 that mists a raw material solution to generate mist; a carrier gas supply unit 130 that supplies a carrier gas for transporting the mist; a film forming unit 140 that subjects the mist to heat treatment and forms a film on a base body; a transport unit 109 that connects the misting unit 120 with an inside of the film forming unit 140, the transport unit including a supply pipe 109a that transports the mist by the carrier gas; and a microwave heating device 200 that irradiates the mist with microwaves to heat the mist, between the misting unit 120 and the base body. In addition, an operation of the film forming apparatus 100 may be controlled by a controller (not illustrated) that controls the entire or a part of the film forming apparatus 100.

According to such a film forming apparatus, it is possible to heat selectively and rapidly only the mist among the mist and the carrier gas to be supplied to the base body (crystalline substrate) 110, thereby suppressing the evaporation of the mist without increasing the saturated water vapor pressure of the carrier gas. Because of this, it is possible to enhance the film forming rate while inhibiting foreign substances and abnormal growth. Furthermore, it is possible to supply the mist of high temperature to the base body 110, and accordingly, the temperature drop of the base body 110 is suppressed even when the supply amount of the mist is increased, and it becomes possible to form the film at a high film forming rate without damaging the crystallinity even on the base body 110 having a large diameter.

### [Misting unit]

In the misting unit 120, the raw material solution is misted to generate mist. The misting means is not particularly limited as long as it can mist the raw material solution, and may be a known misting means, but it is preferable to use a misting means by ultrasonic vibration. This is because the mist can be more stably formed.

An example of such a misting unit 120 is shown in FIG. 2. For example, the misting unit 120 may include a mist generating source 104 including a vessel in which a raw material solution 104a is accommodated, a vessel 105 in which media that can transmit ultrasonic vibration, for example, water 105a is accommodated, and an ultrasonic vibrator 106 attached to a bottom surface of the vessel 105. Specifically, the mist generating source 104 formed of a vessel in which the raw material solution 104a is accommodated is stored in the vessel 105 in which the water 105a is accommodated, with the use of a support (not illustrated). The ultrasonic vibrator 106 is provided at the bottom of the vessel 105, and the ultrasonic vibrator 106 and an oscillator 116 are connected to each other. In addition, the misting unit 120 is configured such that when the oscillator 116 is operated, the ultrasonic vibrator 106 vibrates, then ultrasonic waves are propagated into the mist generating source 104 through the water 105a, and the raw material solution 104a is misted.

### [Carrier gas supply unit]

A carrier gas supply unit 130 includes a carrier gas source 102a that supplies the carrier gas, and may include a flow-rate adjusting valve 103a that adjusts the flow rate of the carrier gas to be sent from the carrier gas source 102a. Furthermore, it is also possible to provide a carrier gas source for dilution 102b, which supplies a carrier gas for dilution, and a flow-rate adjusting valve 103b for adjusting a flow rate of the carrier gas for dilution, which is sent out from the carrier gas source for dilution 102b, as necessary.

The type of the carrier gas is not particularly limited, and can be appropriately selected depending on a film to be formed. Examples of the gas include oxygen, ozone, inert gases such as nitrogen and argon, and reducing gases such as hydrogen gas and forming gas. In addition, the carrier gas may be one type or two or more types. For example, a diluted gas which has been obtained by diluting the same gas as the first carrier gas with another gas (for example, by diluting the gas to ten times) or the like may be further used as a second carrier gas, and air can also be used.

In addition, the portion from which the carrier gas is supplied may be not only one but also two or more.

A flow rate of the carrier gas is not particularly limited. For example, in a case of forming a film on a substrate having a diameter of 10 cm (4 inches), it is preferable to set the flow rate to 1 to 80 L/min, and is more preferable to set to 4 to 40 L/min. Note that the flow rate of the carrier gas in the present invention is set to a measured value at 20°C and normal pressure, and when the flow rate has been measured at other temperatures and pressures or when a different type of flow rate (mass flow rate, etc.) has been measured, the flow rate can be converted to a volume flow rate at 20°C and normal pressure, with the use of the equation of state of gas.

### [Film forming unit]

In the film forming unit 140, the mist is heated to cause a thermal reaction, and a film is formed on a part or the whole of the surface of the base body 110. The film forming unit 140 includes, for example, a film forming chamber 107; and in the film forming chamber 107, the base body 110 is installed, and a hot plate 108 for heating the base body 110 can be provided.

The hot plate 108 may be provided outside the film forming chamber 107 as illustrated in FIG. 1, or may be provided inside the film forming chamber 107. In addition, in the film forming chamber 107, an exhaust port 112 for exhaust gas may be provided at a position that does not affect the supply of mist to the base body 110.

### [Transport unit]

The transport unit 109 has a supply pipe 109a, and connects the misting unit 120 with an inside of the film forming unit 140. The mist is transported by the carrier gas from the mist generating source 104 of the misting unit 120 to a film forming chamber 107 of the film forming unit 140, via the transport unit 109. As the supply pipe 109a, for example, a quartz pipe, a resin-made tube or the like can be used.

### [Microwave heating device]

The microwave heating device is not particularly limited as long as the device can emit microwaves, and includes a known microwave generation unit, a microwave irradiation unit and a microwave waveguide unit that are formed of an electroconductive material such as aluminum, copper or brass, and a part of the supply pipe in the inside of which the mist of a material to be heated passes is arranged in the microwave irradiation unit so as to pass through a microwave irradiation space of the microwave irradiation unit.

An example of a single-mode microwave heating device according to the present invention is shown in FIG. 3. As shown in FIG. 3, the microwave heating device 200 includes: a microwave generation unit 201; a microwave irradiation unit 204, which irradiates the mist with microwaves generated in the microwave generation unit; and a microwave waveguide unit 205, through which the microwaves propagate from the microwave generation unit to the microwave irradiation unit.

Such a microwave heating device can stably irradiate the mist with the microwaves.

The microwave heating device 200 may be arranged in any portion between the misting unit 120 and the base body 110 of the film forming unit 140, and such arrangement is satisfactory that at least a part of the microwave heating device 200 is included in the film forming unit 140. With such an arrangement of the microwave heating device 200, it becomes possible to effectively prevent a decrease in the temperature of the mist due to heat dissipation of the mist heated by the microwaves, and a decrease in the film forming rate due to promotion of evaporation of the mist caused by an increase in the saturated vapor pressure due to an increase in the temperature of the surrounding carrier gas.

The microwave heating device 200 includes a microwave oscillator as a microwave generation unit 201, a waveguide through which microwaves propagate, as a microwave waveguide unit 205, a power monitor 202 for controlling incident and reflected microwave waves, a stub tuner 203 for adjusting an impedance within the device, and an applicator having a microwave irradiation space inside as a microwave irradiation unit 204. The applicator 204 has a short-circuiting surface 206, and is arranged so that a portion of the supply pipe 109a through which the mist 220 and the carrier gas pass passes through the microwave irradiation space in the inside of the applicator 204. In addition, the microwave heating device 200 may include a thermometer 207 which measures the temperature of the supply pipe 109a.

The microwave oscillator 201 may be a magnetron type or a semiconductor (solid state) type, but the semiconductor type is preferable because the fluctuation of the frequency is little.

The material of the waveguide 205 is not particularly limited, and the waveguide may be formed of an electroconductive material such as aluminum, copper or brass. In addition, the outer surface of the waveguide 205 may be coated with an acid-resistant coating. This is because the material is less likely to be corroded even in an acidic raw material solution. The acid-resistant coating agent is not particularly limited, and a known coating agent such as Teflon (registered trademark) can be used.

It is preferable that a portion of the supply pipe 109a, which is arranged in the microwave irradiation unit (hereinafter, also simply referred to as "microwave irradiation portion of the supply pipe") is formed of a microwave-transmissive member.

The microwave irradiation portion of the supply pipe is formed from a material that tends to easily transmit microwaves, and thereby, the microwaves directly reach the mist in the inside of the supply pipe, and can directly heat the mist with microwaves.

The microwave heating can generate heat in a very short time as compared with the conventional heating by heat transfer, and accordingly, the mist can be quickly heated to a predetermined temperature.

The material for forming the microwave irradiation portion of the supply pipe to be irradiated with the microwaves is not particularly limited as long as the material has microwave permeability, and can be appropriately selected according to the purpose; examples thereof include quartz, ceramic, alumina, a polytetrafluoroethylene resin, a tetrafluoroethylene-perfluoroalkyl vinyl ether copolymer resin, a tetrafluoroethylene-hexafluoropropylene copolymer resin, a polyether ether ketone resin, glass, sapphire, a polyethylene resin, and the like; and among the materials, any of quartz, ceramic, alumina, a polytetrafluoroethylene resin, a tetrafluoroethylene-perfluoroalkyl vinyl ether copolymer resin, a tetrafluoroethylene-hexafluoropropylene copolymer resin and a polyether ether ketone resin is more preferable.

Such a material can effectively suppress unintended contamination occurring from a microwave irradiation portion of the supply pipe.

In order to avoid contact between the microwave irradiation portion of the supply pipe and a reaction solution, the inner wall surface of the microwave irradiation portion of the supply pipe may be subjected to surface treatment according to the type of the solvent contained in the reaction solution. For example, when the solvent is water, the surface of the inner wall surface may be subjected to hydrophobic treatment by irradiation with ultraviolet rays, ultrasonic waves and radiation, or may be subjected to hydrophobic treatment which uses a hydrophobic material such as a silane coupling agent or the polytetrafluoroethylene resin.

The shape of the microwave irradiation portion of the supply pipe is not particularly limited, but is preferably tubular. This is because the mist can be uniformly irradiated with the microwaves. The shape in a pipe length direction is not particularly limited and may be appropriately selected according to the purpose, and may be a straight shape (straight pipe) or a shape of a pipe bent in a gentle curve such as a spiral shape (bent pipe). The pipe length is determined in consideration of the size of the microwave irradiation portion of the supply pipe, the size of the applicator 204, the output of the microwaves, the heating time, a flow rate of the carrier gas, and the like. When the heating time is desired to be short, the shape may be a straight line, and when the heating time is desired to be long, the shape may be a bent pipe such as a spiral pipe.

The cross-sectional shape of the microwave irradiation portion of the supply pipe may be circular, elliptical or rectangular, but is preferably circular with satisfactory symmetry.

The thickness of the wall of the microwave irradiation portion of the supply pipe is not particularly limited, and can be appropriately selected according to the purpose; but is preferably from 0.05 mm to 10 mm, and is more preferably from 0.1 mm to 2 mm. When the thickness is in the range of 0.05 mm to 10 mm, it becomes possible to maintain an appropriate strength, to effectively prevent a damage due to pressure fluctuation in the pipe, and to effectively prevent a decrease in heating efficiency due to transmission loss of the microwaves.

In addition, the above specifications of the microwave irradiation portion of the supply pipe can be applied also to the entire supply pipe 109a. In addition, in any case, the material of the portion of the supply pipe 109a, which is not irradiated with the microwaves, is not particularly limited.

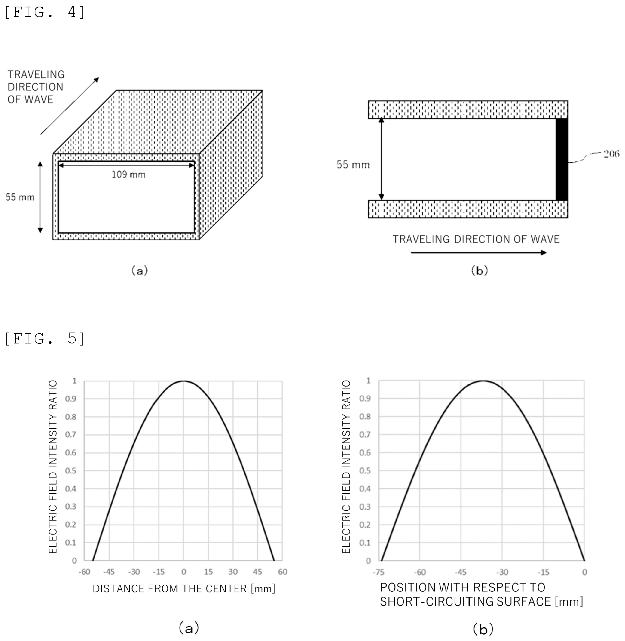

An example of an applicator according to the present invention is shown in FIG. 4 ((a) perspective view, and (b) side sectional view). The material of the applicator 204 is not particularly limited, and may be formed from an electroconductive material such as aluminum, copper or brass.

The outer surface of the applicator 204 may be subjected to an acid-resistant coating. This is because the material is less likely to be corroded even in an acidic raw material solution. The acid-resistant coating agent is not particularly limited, and a known coating agent such as Teflon (registered trademark) can be used.

The shape of the applicator 204 is not particularly limited, and may be circular, elliptical, rectangular, or the like. Specifically, a rectangular waveguide, a circular cavity resonator or the like can be used.

The shape of the standing wave to be formed in the microwave irradiation space of the applicator 204 depends on the frequency of the microwaves and the shape of the microwave irradiation space. The standing wave is a wave motion in which the waveform does not advance but appears to stop and vibrate, and a state is created in which the positions of a place where the electric field intensity is 0 and a place where the electric field intensity is strong do not change with time. It is preferable that the microwave irradiation portions of the applicator 204 and the supply pipe are configured so as to form standing waves of TEn0 and TM0m0 modes (n and m are integers of 1 or larger) in the microwave irradiation space, and so that a difference between the maximum and minimum values of either the electric field intensity or the magnetic field intensity of the standing waves becomes 50% or larger in the region of the microwave irradiation portion of the supply pipe, and is particularly preferable so that the difference becomes 20% or smaller of the maximum value. This is because heating unevenness is reduced.

When microwaves of 2.45 GHz have been used, a standing wave of the TE10 mode is formed in a waveguide (waveguide standard: WRI-22) which has an internal space of 109 mm in the long axis and 55 mm in the short axis. In this mode, there is no change in the electric field intensity in the direction of the short axis of the waveguide. A distribution of the electric field intensity ratio in the long axis direction of the waveguide is as shown in the graph of FIG. 5(a), and the electric field intensity in the traveling direction is as shown in the graph of FIG. 5(b). In the case of such an applicator, the difference between the maximum and minimum values of the electric field intensity of the standing wave in the supply pipe becomes within 20%, by arranging the supply pipe with the inner diameter of within 30 mm at a position of 37 mm from the short-circuiting surface.

As a circular cavity resonator, by setting the inner diameter of the irradiation space within the cavity resonator to 91 mm, as in the microwave heating device (manufactured by Ryowa Electronics Co., Ltd.), it becomes possible to form a TM010 mode of standing wave when microwaves of 2.45 GHz have been used.

In addition, the number of the microwave irradiation portions of the applicator 204 and the supply pipe is not particularly limited. The microwave irradiation portions of the plurality of supply pipes may be arranged at a plurality of places in which the electric field intensity is high which is generated by change of the shape of the applicator.

According to such a configuration, it is possible to increase a volume to be irradiated with the microwaves, without lowering the heating efficiency. Note that when a plurality of microwave irradiation portions of the supply pipe are provided, the heated mist may be supplied to one base body from the plurality of microwave irradiation portions of the supply pipe.

Note that the microwaves also have a heating effect by a magnetic field, and accordingly, it is possible to obtain the same effect even by utilizing a portion at which the magnetic field becomes strong.

### (Crystalline metal oxide film)

Next, the crystalline metal oxide film of the present invention will be described. The crystalline metal oxide film according to the present invention is a crystalline metal oxide film including at least one of gallium or aluminum as a main component, in which the number density of foreign substances observed in a surface direction of the crystalline metal oxide film is less than 48/cm², and a standard deviation in a particle size of the foreign substances is smaller than 1.25 µm.

It is possible to suitably use such a crystalline metal oxide film for a semiconductor device, because the film contains few foreign substances and accordingly has satisfactory smoothness, and the size of the foreign substance is small and uniform; and accordingly, when a semiconductor device is manufactured with use of the crystalline metal oxide film, an influence of the foreign substances on device characteristics becomes minor.

Note that the surface of the crystalline metal oxide film in the present invention refers to one of the front and back surfaces of the crystalline metal oxide film.

The surface direction in the present invention refers to, when a direction from the back surface side to the front surface side of the crystalline metal oxide film is defined as a z-axis positive direction, a direction from a side where the z coordinate is larger than the surface of the crystalline metal oxide film to a side where the z coordinate is smaller.

In the present invention, a position of the foreign substance is not particularly limited as long as the foreign substance can be observed from the surface direction. The foreign substance may be attached to the surface, or may be partially or fully embedded in the film. The observation method will be described later, but is not particularly limited. The height in the observation direction can be distinguished with the use of a confocal microscope or the like.

In general, a crystalline metal oxide film is composed of a metal and oxygen, but in the crystalline metal oxide film according to the present invention, the metal contains at least one of gallium or aluminum as a main component. The main component as used herein means that 50 to 100 atom% of the metal component is gallium or aluminum. In addition, the main component also means that the total of gallium and aluminum is 50 to 100 atom%.

As a metal component other than gallium or aluminum, for example, one or more metals selected from iron, indium, vanadium, titanium, chromium, rhodium, iridium, nickel and cobalt may be contained.

In the crystalline metal oxide film, the number of foreign substances observed in the surface direction of the film is less than 48/cm², is preferably 10/cm² or less, and is further preferably less than 1/cm². The lower limit of the foreign substances is not particularly limited. It may be 0.01/cm² or more.

It becomes possible to further suitably use such a crystalline metal oxide film for a semiconductor device, because the film contains few foreign substances and accordingly has satisfactory smoothness.

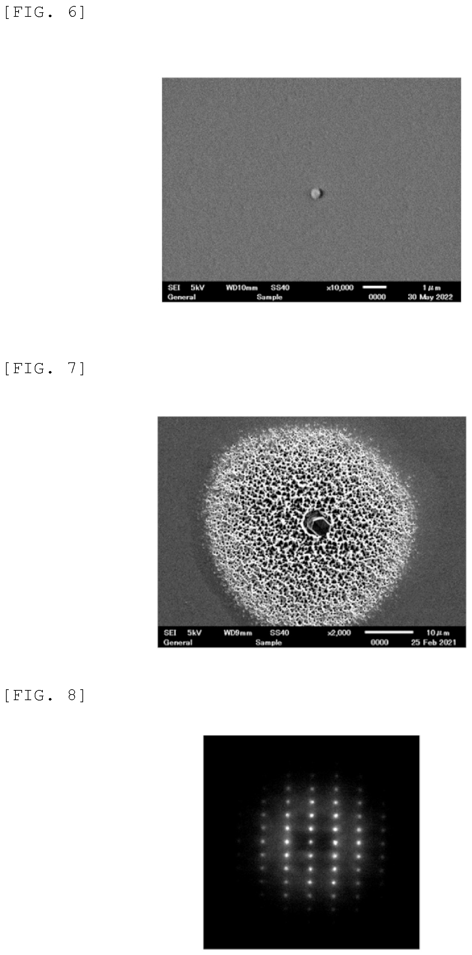

In addition, the foreign substance according to the present invention is a particle as shown in FIG. 6, which is derived from the metal raw material in the mist. The mechanism by which the foreign substance is formed is not clear, but it is considered that the metal raw material has been deposited due to the evaporation of the moisture in the mist during film formation, and that a metal oxide has been formed due to a side reaction of the metal raw material in the gas phase. The majority of these particles are amorphous. The method of analyzing the compositions of the particles is not particularly limited. The composition can be examined by EDX, Auger electron spectroscopy, SIMS, or the like. In addition, the analysis method of the crystal structure is not also particularly limited. The crystal structure can be examined by a general method such as electron beam diffraction.

When these particles are attached to or embedded in the film surface, a part or all of the particles are crystallized by heat. However, at this time, not the α phase but the γ phase of an aluminum oxide crystal or a gallium oxide crystal, or mixed crystals thereof grow. Because of this, when a voltage is applied to a film in which the foreign substance is found, an electric field concentrates on a grain boundary portion between the α phase and the γ phase, and dielectric breakdown easily occurs. When the number density of the foreign substances is less than 48/cm², dielectric breakdown due to the formation of the grain boundary can be sufficiently suppressed, and accordingly, a semiconductor device can be manufactured at a high yield, with the use of the crystalline metal oxide film.

Shape observation and evaluation of the number of occurrences of the foreign substance can be performed with an electron microscopy such as TEM, an optical microscopy, a surface-inspection device that detects defects from a difference in brightness, a surface-inspection device that uses an image-recognition AI and makes a machine learn and detect defects, or the like, in addition to the SEM that observes the foreign substance in FIG. 6, but the observation method and the method of evaluating the number of occurrences are not particularly limited.

A particle size of the foreign substance in the present invention is 10 nm to 10 µm. Note that the particle size which is used herein refers to a circle-equivalent diameter in a two-dimensional image observed from the surface direction of the crystalline metal oxide film. The circle-equivalent diameter is a diameter of a circle having an area equivalent to an area of a particle captured in the two-dimensional image, and the particle area can be calculated by image analysis or the like.

The particle size distribution can be created by calculating the particle size of the foreign substance according to the previously described method. In the crystalline metal oxide film according to the present invention, the standard deviation (σ) of the particle size is smaller than 1.25 µm, is preferably smaller than 0.50 µm, and is more preferably 0.30 µm or smaller. The σ is preferable when it is smaller, and accordingly the lower limit is, for example, more than 0 um. Such a crystalline metal oxide film can be suitably used for a semiconductor device, because the size of the foreign substance is small and uniform, and when the semiconductor device has been manufactured with the use of the crystalline metal oxide film, the influence of the foreign substance on the device characteristics becomes minor. Note that the σ can be obtained according to the following expression.$σ = \sqrt{\frac{1}{n} {\sum }_{i = 1}^{n} {\left({x}_{i}-{x}^{˜}\right)}^{2}}$ where n is the number of data, xᵢ is each data, and x̃ bar is an average value.

In addition, in the crystalline metal oxide film according to the present invention, the index of the particle size distribution D90/D10 may be smaller than 5.7, is preferably 4.0 or smaller, and is more preferably 3.0 or smaller.

In such a crystalline metal oxide film, the size of the foreign substance is more uniform, the design of the semiconductor device becomes easier, and the crystalline metal oxide film can be suitably used for the semiconductor device. The lower limit is not particularly limited, but is usually about 1.5.

Note that the particle size D90 in the present invention refers to a particle size at which a cumulative ratio in the particle size distribution becomes 90%, the particle size D10 refers to a particle size at which the cumulative ratio becomes 10%, and the particle size D50 refers to a particle size at which the cumulative ratio becomes 50%.

The value of the particle size D90 is not particularly limited, but for example, may be smaller than 4.25 µm, and is more preferably 1.0 µm or smaller. In addition, the lower limit is not particularly limited. The smaller the value is, the more satisfactory it is, and for example, the value can be larger than 1 nm.

Such a crystalline metal oxide film can be suitably used for a semiconductor device, because the size of the foreign substance is small, and when the semiconductor device has been manufactured with the use of the crystalline metal oxide film, the influence of the foreign substance on the device characteristics becomes further minor.

The value of the particle size D10 is not particularly limited. The smaller the particle size is, the crystalline metal oxide film can be suitably used for a semiconductor device, because when the semiconductor device has been manufactured, the influence of the foreign substance on the device characteristics becomes minor.

In addition, in the crystalline metal oxide film according to the present invention, the particle size D50 at which the cumulative ratio in the particle size distribution becomes 50% may be smaller than 2.75 µm, is preferably 2.0 µm or smaller, and is more preferably 0.5 µm or smaller. In addition, the lower limit is not particularly limited. The smaller the value is, the more satisfactory it is, and for example, the value can be larger than 1 nm.

Such a crystalline metal oxide film can be suitably used for a semiconductor device, because the foreign substance is small, and when the semiconductor device has been manufactured, the influence of the foreign substance on the device characteristics becomes further minor.

In the crystalline metal oxide film according to the present invention, the ratio of particles having a particle size not smaller than (particle size D50 - standard deviation σ) and not larger than (particle size D50 + standard deviation σ) to the total number of foreign substances may be 60% or larger, and is more preferably 75% or larger.

In such a crystalline metal oxide film, the size of the foreign substance is more uniform, the design of the semiconductor device becomes easier, and the crystalline metal oxide film can be suitably used for the semiconductor device.

In addition, the crystalline metal oxide film may have a corundum structure.

Such a crystalline metal oxide film becomes a crystalline metal oxide film having a corundum structure, in which the smoothness is more satisfactory.

In addition, in the crystalline metal oxide film according to the present invention, the half width of the rocking curve of X-ray diffraction peak on a (006) plane may be smaller than 19.1 seconds, and is more preferably 9.4 seconds or smaller.

A measurement apparatus and a measurement method of the half width of the X-ray diffraction peak on a (006) plane are not particularly limited. For example, an X-ray diffractometer (SmartLab manufactured by Rigaku Holdings Corporation) is used to perform Out-of-Plane XRD 2θ/ω scan measurement of an oxide semiconductor film formed on a base body, and 2θ and ω are examined at which the peak of the (006) plane is obtained. After that, the half width of the rocking curve can be measured by fixing the diffraction angle at 2θ at which the peak of the (006) plane has been obtained, and by performing ω scan.

The measurement conditions at this time are not particularly limited, and can be, for example, as follows.
· Measurement apparatus: SmartLab (trade name) manufactured by Rigaku Holdings Corporation
· Analysis conditions
   Measurement method: Out-of-Plane XRD method (2θ/ω scan)
   X-ray generating unit: counter cathode Cu
      : output 45 kV 200 mA
      Detection unit: semiconductor detector
   Incident optical system: Ge (220) channel cut monochromator
   Soller slit: incident side -
      : light receiving side 5.0°
   Slit: incident side IS= 1 (mm)
      : longitudinal limit 0.5 (mm)
      : light receiving side RS1= 1 RS2= 1.1 (mm)
   Scanning conditions: scanning axis 2θ/ω
      : scanning mode step measurement
      : scanning range 35 to 45°
      : step width 0.005°
      : accumulation time 0.5 sec./step
· Measurement apparatus: SmartLab (trade name) manufactured by Rigaku Holdings Corporation
· Analysis conditions
   Measurement method: rocking curve measurement (ω scan)
   X-ray generating unit: counter cathode Cu
      : output 45 kV 200 mA
      Detection unit: semiconductor detector
   Incident optical system: Ge (220) channel cut monochromator
   Soller slit: incident side -
      : light receiving side 5.0°
   Slit: incident side IS= 1 (mm)
      : longitudinal limit 0.5 (mm)
      : light receiving side RS1= 1 RS2= 1.1 (mm)
   Scanning conditions: evaluation diffractive surface Ga₂O₃ (006)
      : scanning axis ω
      : scanning mode step measurement
      : scanning range 19 to 22°
      : step width 0.005°
      : accumulation time 0.5 sec./step

It becomes possible for such a crystalline metal oxide film to be suitably used for a semiconductor device, because the crystal orientation is more satisfactory. Note that the half width of the rocking curve is preferable when it is smaller, and accordingly, the lower limit is, for example, more than 0 seconds.

The crystalline metal oxide film can contain a dopant depending on an application. The dopant is not particularly limited. Examples of the dopant include n-type dopants such as tin, germanium, silicon, titanium, zirconium, vanadium and niobium, and p-type dopants such as copper, silver, tin, iridium and rhodium. The concentration of the dopant may be, for example, about 1.0×10¹⁶ to 1.0×10²² /cm³, and may be set to a low concentration of about 1.0×10¹⁷ /cm³ or lower, or to a high concentration of about 1.0×10²⁰ /cm³ or higher.

The film thickness of the crystalline metal oxide film according to the present invention is not particularly limited. For example, it may be 0.05 to 100 µm, is preferably 0.1 to 50 µm, and is more preferably 0.5 to 20 µm.

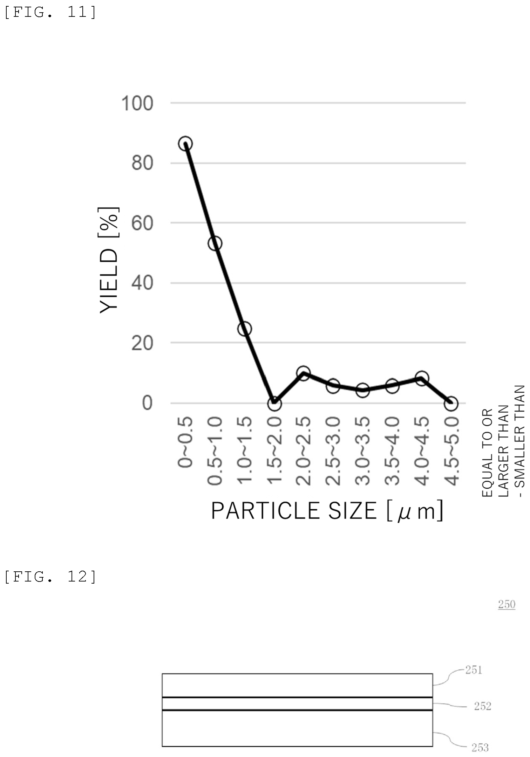

The crystalline metal oxide film may be formed directly on the base body, or may be layered on an intermediate layer 252 (buffer film or release film) formed on a base body 253, as shown in FIG. 12. The intermediate layer is not particularly limited as long as the composition is a metal oxide capable of forming a corundum structure, and can contain an oxide containing, for example, any of aluminum, titanium, vanadium, chromium, iron, gallium, rhodium, indium and iridium, as a main component.

More specifically, the intermediate layer is Al₂O₃, Ti₂O₃, V₂O₃, Cr₂O₃, Fe₂O₃, Ga₂O₃, Rh₂O₃, In₂O₃ and Ir₂O₃; and may be a metal oxide of a binary system represented by (AₓB₁₋ₓ)₂O₃ (0<x<1) when two elements selected from the above metallic elements are determined as A and B, or a metal oxide of a ternary system represented by (AₓB_{y}C_{1-x-y})₂O₃(0<x<1, 0<y<1) when three elements selected from the above metallic elements are determined as A, B and C.

It is preferable that a diameter of the crystalline metal oxide film is 10 cm (4 inches) or larger. The upper limit of the area is not particularly limited, but may be 750 cm² or smaller, and in the case of a circular shape, the area may correspond to the diameter of 12 inches (300 mm) or smaller.

Such a crystalline metal oxide film can be further suitably used for a semiconductor device, due to having more satisfactory smoothness and a large area.

The crystalline metal oxide film according to the present invention can be used for a semiconductor device, by appropriately designing the structure. Note that examples of the semiconductor device will be described later in detail.

### (Method for producing crystalline metal oxide film)

As for a method for producing the crystalline metal oxide film according to the present invention, the film can be formed by a mist CVD method including a step of heating with microwaves as will be described later.

### (Layered structure)

FIG. 12 is a view showing an embodiment of the structure of a layered structure according to the present invention. The layered structure 250 having the crystalline metal oxide film according to the present invention basically includes the base body 253 and the crystalline metal oxide film 251. At this time, the previously described intermediate layer 252 may be included between the base body 253 and the crystalline metal oxide film 251.

The crystalline metal oxide film and the layered structure according to the present invention can be used for a semiconductor device, due to appropriate designing of the structure. The crystalline metal oxide film and the layered structure can constitute the semiconductor layer of each of, for example, a Schottky barrier diode (SBD), a metal semiconductor field-effect transistor (MESFET), a high electron mobility transistor (HEMT), a metal oxide semiconductor field-effect transistor (MOSFET), a static induction transistor (SIT), a junction field-effect transistor (JFET), an insulated gate bipolar transistor (IGBT), a light emitting diode (LED), and the like.

### (Semiconductor Device)

In addition, the semiconductor device according to the present invention includes at least one of the above described crystalline metal oxide film and/or the above described layered structure. For example, a semiconductor device (semiconductor element) such as a semiconductor laser, a diode or a transistor can be provided. Such a semiconductor device may be the device including the base body or may be the device from which the base body is removed. The semiconductor device according to the present invention is a high-quality semiconductor device in which a high-quality crystalline metal oxide film with satisfactory flatness is used. Application examples (specific examples) of the semiconductor device are as follows.

### (Examples of applicable semiconductor device)

The crystalline metal oxide film and the layered structure including the crystalline metal oxide film as described above have satisfactory flatness and excellent electrical characteristics, and are industrially useful. Such a crystalline metal oxide film and a layered structure having a crystalline metal oxide film can be suitably used for various semiconductor devices and the like, and are particularly useful for a power device.

In addition, semiconductor devices can be classified into a horizontal element (horizontal device) in which an electrode is formed on one surface side of a crystalline metal oxide film, and a vertical element (vertical device) in which an electrode is formed on both front and back surface sides of the crystalline metal oxide film. The semiconductor device of the present invention can be suitably used for both the horizontal device and the vertical device, but is preferably used for the vertical device. Examples of the semiconductor device include a Schottky barrier diode (SBD), a metal semiconductor field-effect transistor (MESFET), a high electron mobility transistor (HEMT), a semiconductor field-effect transistor (MOSFET), a junction field-effect transistor (JFET), an insulated gate bipolar transistor (IGBT), and a light-emitting diode (LED).

### (Method for manufacturing semiconductor device)

First, a crystalline metal oxide film is formed on a main surface of a base body directly or via another layer, and a layered structure according to the present invention is obtained. After that, an electrode and the like are formed on the crystalline metal oxide film, and thereby, a semiconductor device is manufactured. At this time, the layered structure including the base body and the crystalline metal oxide film can be used as it is, or the base body may be removed to leave the intermediate layer and the crystalline oxide semiconductor film, or the base body and the intermediate layer may be removed to leave only the crystalline oxide semiconductor film. In this way, a high-performance semiconductor device which uses a high-quality crystalline metal oxide film with satisfactory flatness can be manufactured.

Preferable examples of the case in which the crystalline metal oxide film of the present invention is applied to an n-type semiconductor layer (n+-type semiconductor, n--type semiconductor layer, or the like) will be described below with reference to the drawings, but the present invention is not limited to these examples. Note that the semiconductor elements exemplified below may further include another layer (for example, an insulator layer or a conductor layer) or the like, and, for example, an intermediate layer or a stress relief layer (a buffer layer) may be omitted as appropriate.

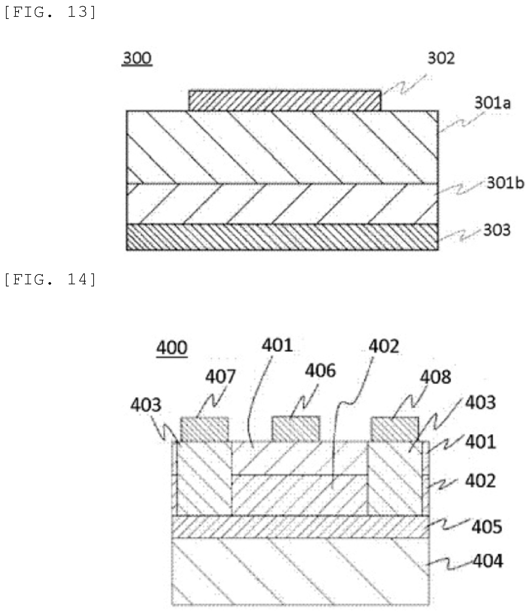

FIG. 13 shows an example of an SBD (Schottky barrier diode) according to the present invention. The SBD 300 includes an n--type semiconductor layer 301a which has been subjected to a relatively low concentration of doping, an n+-type semiconductor layer 301b which has been subjected to a relatively high concentration of doping, a Schottky electrode 302, and an ohmic electrode 303.

The material of the Schottky electrode 302 and the ohmic electrode 303 may be a known electrode material, and examples of the electrode materials include: metals such as aluminum, molybdenum, cobalt, zirconium, tin, niobium, iron, chromium, tantalum, titanium, gold, platinum, vanadium, manganese, nickel, copper, hafnium, tungsten, iridium, zinc, indium, palladium, neodymium and silver, or alloys thereof; electroconductive films of metal oxides such as tin oxide, zinc oxide, rhenium oxide, indium oxide, indium tin oxide (ITO) and indium zinc oxide (IZO); organic electroconductive compounds such as polyaniline, polythiophene and polypyrrole; and mixtures and layered products thereof.

The Schottky electrode 302 and the ohmic electrode 303 can be formed by a known method such as a vacuum deposition method or a sputtering method. More specifically, for example, in the case of forming a Schottky electrode with the use of two types of metals among the above metals, which are a first metal and a second metal, the Schottky electrode can be formed by stacking a layer formed from the first metal and a layer formed from the second metal, and subjecting the layer formed from the first metal and the layer formed from the second metal to patterning which uses a photolithographic method.

When a reverse bias has been applied to the SBD 300, a depletion layer (not illustrated) spreads into the n--type semiconductor layer 301a, and accordingly, the SBD 300 results in having a high withstand voltage. In addition, when a forward bias has been applied, electrons flow from the ohmic electrode 303 to the Schottky electrode 302. Accordingly, the SBD according to the present invention is excellent for high withstand voltage and large current, has a high switching speed, and is excellent also in withstand voltage and reliability.

FIG. 14 shows an example of a HEMT (high electron mobility transistor) according to the present invention. The HEMT 400 includes an n-type semiconductor layer 401 having a wide band gap, an n-type semiconductor layer 402 having a narrow band gap, an n+-type semiconductor layer 403, a semi-insulating layer 404, a stress relief layer 405, a gate electrode 406, a source electrode 407, and a drain electrode 408.

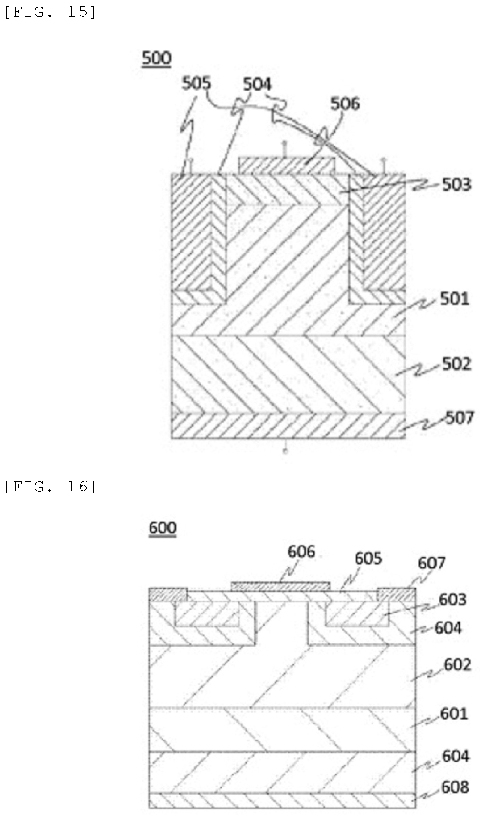

FIG. 15 shows an example of a MOSFET (semiconductor field-effect transistor) according to the present invention. The MOSFET 500 includes an n--type semiconductor layer 501, n+-type semiconductor layers 502 and 503, gate insulating films 504, gate electrodes 505, a source electrode 506, and a drain electrode 507.

FIG. 16 shows an example of an IGBT (insulated gate bipolar transistor) according to the present invention. The IGBT 600 includes an n-type semiconductor layer 601, an n--type semiconductor layer 602, an n+-type semiconductor layer 603, a p-type semiconductor layer 604, a gate insulating film 605, a gate electrode 606, an emitter electrode 607, and a collector electrode 608.

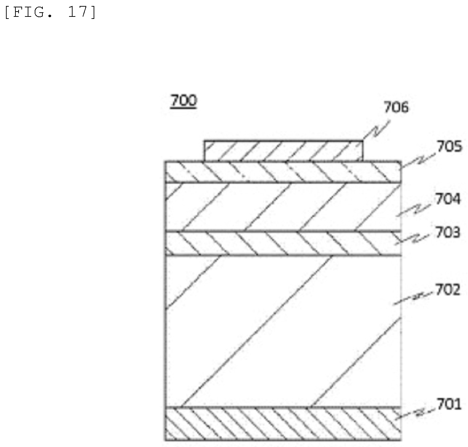

FIG. 17 shows an example of an LED (light emitting diode) according to the present invention. The LED 700 includes a first electrode 701, an n-type semiconductor layer 702, a light-emitting layer 703, a p-type semiconductor layer 704, a translucent electrode 705, and a second electrode 706.

Examples of the material of the translucent electrode include an electroconductive material of an oxide containing indium or titanium, etc. More specific examples thereof include In₂O₃, ZnO, SnO₂, Ga₂O₃, TiO₂, CeO₂, a mixed crystal of two or more thereof, and doped versions thereof.

The translucent electrode can be formed by providing these materials with a known means such as sputtering. In addition, after the translucent electrode has been formed, the translucent electrode may be subjected to thermal annealing for the purpose of transparency.

Examples of the material of the first electrode 701 and the second electrode 706 include: metals such as aluminum, molybdenum, cobalt, zirconium, tin, niobium, iron, chromium, tantalum, titanium, gold, platinum, vanadium, manganese, nickel, copper, hafnium, tungsten, iridium, zinc, indium, palladium, neodymium and silver, or alloys thereof; electroconductive films of metal oxides such as tin oxide, zinc oxide, rhenium oxide, indium oxide, indium tin oxide (ITO), and indium zinc oxide (IZO); organic electroconductive compounds such as polyaniline, polythiophene and polypyrrole; and mixtures thereof.

A method for forming the film of the electrode is not particularly limited, and the electrode can be formed on the above substrate according to a method appropriately selected in consideration of suitability for the above material, from: a wet method such as a printing method, a spray method or a coating method; a physical method such as a vacuum deposition method, a sputtering method or an ion plating method; a chemical method such as CVD or a plasma CVD method; and the like.

### (Film forming method)

Next, a film forming method of the present invention will be described. A film forming method of the present invention includes the steps of: generating mist by atomizing or dropletizing a raw material solution, transporting the mist to a film forming unit by a carrier gas, heating the mist with microwaves before the mist reaches a base body installed in the film forming unit, and forming a film on the base body by supplying the mist to the base body in the film forming unit and subjecting the mist to heat treatment on the base body.

According to such a film forming method, it is possible to heat selectively and rapidly only the mist among the mist and the carrier gas supplied to the base body, thereby suppressing the evaporation of the mist without increasing the saturated water vapor pressure of the carrier gas. Because of this, it is possible to enhance the film forming rate while inhibiting foreign substances and abnormal growth. Furthermore, it is possible to supply the mist of high temperature to the base body, and accordingly, the temperature drop of the base body is suppressed even if the supply amount of the mist is increased; and it becomes possible to form the film at a high film forming rate without damaging the crystallinity even on the base body having a large diameter.

Embodiments of a film forming method of the present invention will be described below, with reference to an example of a film forming method using a film forming apparatus 200 according to the present invention shown in FIG. 1.

First, a base body 110 is placed on a hot plate 108, and the hot plate 108 is operated. Flow-rate adjusting valves 103a and 103b are opened to supply the carrier gas from a carrier gas source 102a (main carrier gas) and a carrier gas source for dilution 102b (carrier gas for dilution) into a film forming chamber 107 through a transport unit 109, an atmosphere of the film forming chamber 107 is sufficiently replaced with the carrier gas, and the flow rates of the main carrier gas and the carrier gas for dilution are each adjusted and controlled.

### [Step of atomizing or dropletizing raw material solution to generate mist]

The raw material solution 104a is accommodated in a mist generating source 104 of a misting unit 120, an ultrasonic vibrator 106 is vibrated, the vibration is propagated to the raw material solution 104a through water 105a, and thereby the raw material solution 104a is atomized or dropletized to generate mist.

As the raw material solution 104a, it is preferable to use a solution containing a metallic raw material and at least one type of solvent selected from water, methanol, ethanol, ethylene glycol, diethylene glycol, propylene glycol, tetraethylene glycol, glycerol, benzyl alcohol, and dipropylene glycol.

By using such a solvent, it becomes possible to selectively and rapidly heat the mist by microwave heating.

The raw material solution (aqueous solution) 104a is not particularly limited as long as the solution contains a material that can be misted, and may be an inorganic material or an organic material. As the raw material solution 104a, a solution of a metal or a metallic compound is suitably used; and it is possible to use a solution containing one or more metals selected from the group consisting of gallium, iron, indium, aluminum, vanadium, titanium, chromium, rhodium, nickel and cobalt, but it is preferable to use a solution particularly containing Ga.

Thereby, it is possible to stably produce an α-Ga₂O₃ film.

The raw material solution 104a is not particularly limited as long as the solution can mist the above metal solution, but as the raw material solution 104a, it is possible to suitably use a solution in which a metal is dissolved or dispersed in a form of a complex or a salt in an organic solvent or water. Examples of the form of the complex include an acetylacetonate complex, a carbonyl complex, an ammine complex, and a hydride complex. Examples of the form of the salt include a metal chloride salt, a metal bromide salt, and a metal iodide salt.

In addition, it is possible to use also a solution in which the above metal is dissolved in hydrobromic acid, hydrochloric acid, hydroiodic acid or the like, as an aqueous solution of a salt. It is preferable for the concentration of solutes to be 0.01 to 1 mol/L, is more preferable to be 0.05 to 0.5 mol/L, and is further preferable to be 0.08 to 0.30 mol/L. When the concentration is within such a range, it is possible to efficiently prevent a decrease in the film forming rate, and contamination of foreign substances and abnormal growth due to a side reaction and deposition of an excessive amount of the raw material.

The solvent for dissolving the metallic raw material in the present invention has microwave absorbing properties, and it is possible to use acidic solvents such as acetic acid, nitric acid and formic acid, basic solvents such as an aqueous sodium hydroxide solution, an aqueous potassium hydroxide solution and ammonia water, and the like, in addition to water and alcohols such as methanol, ethanol, ethylene glycol, diethylene glycol, propylene glycol, tetraethylene glycol, glycerol, benzyl alcohol and dipropylene glycol described above. Among the solvents, it is particularly preferable to use a solvent containing water as a main component. When the solvent contains water as the main component, the solvent resists making impurities derived from the solvent remain in the film, is excellent in the atomization efficiency, and is advantageous also in terms of cost.

Note that in the present invention, the "main component" is a component having the highest content with respect to all components, and means that the content is preferably 50% by mass or more, more preferably 70% by mass or more, further preferably 90% by mass or more, and may also be 100% by mass.

In addition, an additive agent such as a substance containing a halogen (for example, hydrohalic acid) or an oxidizing agent may be mixed to the raw material solution 104a. Examples of the hydrohalic acid include hydrobromic acid, hydrochloric acid, hydroiodic acid and the like, and among the acids, hydrobromic acid or hydroiodic acid is preferable. Examples of the oxidizing agent include peroxides such as hydrogen peroxide (H₂O₂), sodium peroxide (Na₂O₂), barium peroxide (BaO₂), benzoyl peroxide (C₆H₅CO)₂O₂, and the like; and organic peroxides such as hypochlorous acid (HClO), perchloric acid, nitric acid, ozone water, peracetic acid, nitrobenzene, and the like.

Furthermore, the raw material solution 104a may contain a dopant. The dopant is not particularly limited. Examples thereof include n-type dopants such as tin, germanium, silicon, titanium, zirconium, vanadium and niobium, and p-type dopants such as copper, silver, tin, iridium and rhodium. The concentration of the dopant may be, for example, about 1.0×10⁻⁹ to 1.0 mol/L, and may be set to a low concentration of about 1.0×10⁻⁷ mol/L or lower, or also to a high concentration of about 0.01 mol/L or higher.

Note that when a crystalline metal oxide film formed of two or more types of metals (for example, an α-(AlₓGa₁₋ₓ)₂O₃ film (0≤X<1)) is formed, a raw material solution 104a, in which each of metallic raw material solutions is separately mixed, may be accommodated and misted in the mist generating source 104 in one misting unit 120, or a plurality of misting units may be provided, and the respective metallic raw material solutions may be misted in the respective misting units. When a plurality of misting units have been provided, a mist mixer (not illustrated) may be provided for mixing each of the raw material solutions which have been misted, or also the mist may be separately supplied to the film forming chamber without providing the mist mixer.

### [Step of transporting mist to film forming unit by carrier gas]

In the step of transporting the mist to the film forming unit 140 by the carrier gas, the mist is transported from the misting unit 120 to the film forming unit 140 via the transport unit 109 by the carrier gas, and is introduced into the film forming chamber 107. The mist transported by the carrier gas simultaneously passes through the microwave heating device 200 that is arranged between the misting unit 120 and the base body 110 which is arranged in the film forming chamber 107.

### [Step of heating mist with microwaves before mist reaches base body installed in film forming unit]

In the microwave heating device 200, microwaves (2.45 GHz) generated by the microwave oscillator 201 are propagated through the waveguide 205, and the microwave irradiation portions of the supply pipe, which is arranged in the applicator 204 and through which the mist 220 and the carrier gas pass, are irradiated with the microwaves. At this time, the positions of the stub tuner 203 and the short-circuiting surface 206 are adjusted so that a standing wave of the TE10 mode is formed. Microwave heating can be performed in this way.

The microwave heating is performed after the mist 220 has left the misting unit 120 and before the mist reaches the base body 110 installed in the film forming unit 140.

In general, in order to improve the film forming rate in the mist CVD method, it is necessary to increase the supply amount of the mist. However, when a large amount of mist is supplied, the temperature of the base body 110 is lowered, and the crystallinity of the film is lowered. On the other hand, by performing the microwave heating of the present invention, a high-temperature mist can be supplied onto the base body 110, and accordingly, the heat can be suppressed from being taken away from the base body 110; and it becomes possible to improve the film forming rate while suppressing the lowering of the crystallinity.

Furthermore, in the heat transfer heating using a heater or the like, the temperature of not only the mist but also the carrier gas rises, and accordingly, the saturated vapor pressure increases and the evaporation of the mist is promoted. Because of this, the raw material in the mist tends to be easily deposited, adheres or is embedded in the film as a foreign substance, and causes the lowering of the film quality. On the other hand, in the case of microwave heating of the present invention, it is possible to directly heat the mist 220 without warming the carrier gas. As a result, the saturated vapor pressure does not increase, and it is possible to raise the temperature of the mist without promoting the evaporation of the mist, and improve the film forming rate without lowering the film quality.

The system of emitting the microwaves is not particularly limited. The microwaves may be emitted in a multimode manner represented by a microwave oven, or may be emitted in a single-mode manner in which one standing wave is formed in the waveguide. As the microwave irradiation means to be used in the present invention, a single-mode manner is preferable. This is because the microwave irradiation portion of the supply pipe is arranged in the region in which the electric field intensity is strong, thereby, the mist can be efficiently irradiated with the microwaves, and the heating efficiency is high.

The microwaves are output from the microwave oscillator 201, and are reflected by the short-circuiting surface 206. At this time, by adjusting the positions of the stub tuner 203 and the short-circuiting surface 206, the standing wave can be formed in the waveguide 205 and the applicator 204. In the microwave heating, a part of energy of the output microwaves is absorbed by the mist in the microwave irradiation portion of the supply pipe, and the remaining part is returned to the microwave oscillator 201 and is absorbed.

A method of controlling the microwave output is not particularly limited. The output may be kept constant, or the power consumption (incident wave power - reflected wave power) may be controlled to be kept constant, or the temperature of the microwave irradiation portion of the supply pipe may be measured and fed back to automatically adjust the output so that the temperature becomes constant. It is preferable to control the power consumption or the temperature, and it is more preferable to control the temperature. This is because the temperature of the heated portion resists varying with time.

Note that the method for measuring the temperature is not particularly limited, but in the case of measuring the temperature of the microwave emitting portion, it is recommended to use an infrared radiation thermometer, an optical fiber thermometer or the like depending on a measurement target, in order to suppress the thermometer from absorbing microwaves. Note that, at this time, it is preferable that the temperature measuring portion of the optical fiber thermometer uses a microwave-transmissive material such as a nonmetal.

The irradiation intensity of the microwaves is not particularly limited and may be appropriately selected depending on the raw material solution, but in the case where the mist is heated, it is preferable for the irradiation intensity to be 0.1 mW to 20 kW, and is more preferable to be 1 mW to 500 W. When the irradiation intensity is in the range of 0.1 mW to 20 kW, it is possible to effectively heat the mist, and effectively suppress the electric discharge in the applicator 204.

In addition, the frequency of the microwaves is not particularly limited. The frequency can be appropriately selected depending on the physical properties of the raw material solution. For example, when water is the solvent, it is preferable to set the frequency to 0.9 GHz or higher and 300 GHz or lower, at which water can absorb the microwaves.

When the frequency is in this range, it is possible to stably heat the mist, and keep the penetration depth of the microwaves to an appropriate length, and uniformly heat even the inside of the mist.

It is particularly preferable to set the frequency of the microwaves to 2.45 GHz or higher and 25 GHz or lower.

When the frequency is in this range, it is possible to more stably heat the mist, and keep the penetration depth of the microwaves to an appropriate length, and more uniformly heat even the inside of the mist.

When the microwaves irradiate the applicator 204, if the mist 220 is excessively supplied with respect to the volume of the microwave irradiation region of the microwave irradiation portion of the supply pipe, the absorption of the microwaves by the mist 220 increases, and the microwaves may not resonate. Because of this, when the flow rate of the mist and the flow rate of the carrier gas are represented by m [cm³/s] and q [cm³/s], respectively, in the case in which the solvent of the reaction solution is water, it is preferable to satisfy m/q ≤ 1/450, and in the case in which the reaction solution is alcohol, it is preferable to satisfy m/q ≤ 1/200. When m/q is in the above range, the microwaves stably resonate, and it is possible to effectively prevent a decrease in the heating efficiency of the mist. The lower limit of m/q is not particularly limited, but is preferably set to 1/45000 or larger. If the ratio is smaller than 1/45000, the productivity becomes worse because the supply amount of the mist is small.

Note that the flow rate of the mist can be calculated from the consumption amount of the raw material solution per hour and the density of the raw material solution. In addition, the flow rate of the carrier gas is determined to be a value in terms of 20°C, and when the temperature is different, the flow rate can be converted to a flow rate at 20°C from the equation of state of gas.

### [Step of supplying mist to base body in film forming unit, and performing heat treatment on base body to form film on base body]

In the film forming step, the mist is supplied onto the base body 110 placed on the hot plate 108, then, the mist is subjected to heat treatment (thermal reaction) by the heat of the hot plate 108 on the base body 110 in the film forming chamber 107, and thereby, a film is formed on the base body 110.

The base body 110 is not particularly limited as long as the base body can have a film formed thereon and support the film. The base body may be a known base body. The base body may be an insulator, a conductor, a semiconductor, a single crystal, or a polycrystal. For example, polysulfone, polyethersulfone, polyphenylene sulfide, polyether ether ketone, polyimide, polyetherimide, and a fluororesin; metals such as iron, aluminum, stainless steel, and gold; and silicon, sapphire, quartz, glass, gallium oxide, lithium niobate and lithium tantalate are examplified, but the examples are not limited to these substances.

In addition, it is preferable to use a base body in which aluminum is the main component metal element contained in the largest amount, among the metal elements contained in the base body 110. In particular, it is preferable to use a sapphire wafer, from the viewpoint of quality and cost.

The plane orientation of the principal plane of the base body 110 is not particularly limited, and in the case of the sapphire wafer, a main surface, for example, such as a c-plane, an m-plane or an a-plane can be used. In addition, the principal plane may have an off-angle with respect to the just surface. The off-angle is not particularly limited, but is preferably 0° to 15°.

The thickness of the base body 110 is not particularly limited, but is preferably about 200 to 800 µm from the viewpoint of cost.

In addition, it is recommended that a main surface of the base body 110 has a diameter of about 10 cm (4 inches) or larger, and it is more preferable that the diameter is about 15 cm (6 inches) or larger. The upper limit size of the main surface of the base body 110 is not particularly limited, but may be 750 cm² or smaller, and in the case of a circular shape, it is preferable that the area corresponds to the diameter of 12 inches (300 mm) or smaller.

When the base body 110 is set to have a large diameter in this way, the crystalline metal oxide film formed on the base body 110 becomes of further higher quality and higher productivity.

A shape of the base body 110 is not particularly limited in the present invention.

The base body 110 may be placed on the top surface of the film forming chamber 107 to be laid face down, or the base body 110 may be placed on the bottom surface of the film forming chamber 107 to be laid face up.

As for the heat treatment (thermal reaction) of the mist supplied onto the base body 110, the mist may react by heating, and the reaction conditions and the like are not particularly limited. The reaction conditions and the like can be appropriately set depending on the raw material and the film to be formed. For example, it is preferable for the heating temperature to be in a range of 120°C to 600°C, is more preferable to be in a range of 200°C to 600°C, and is further preferable to be in a range of 400°C to 550°C.

The heat treatment (thermal reaction) may be performed in any atmosphere of a vacuum, a non-oxygen atmosphere, a reducing gas atmosphere, an air atmosphere and an oxygen atmosphere, and may be appropriately set depending on the film to be formed. In addition, the film may be formed under any condition of reaction pressure, that is, under an atmospheric pressure, an elevated pressure, or reduced pressure, but it is preferable that the film is formed under the atmospheric pressure, because the apparatus configuration can be simplified.

The film may be formed directly on the base body 110, or may be layered on an intermediate layer (buffer film or release film) which has been formed on the base body 110. The intermediate layer is not particularly limited as long as the composition is a metal oxide capable of forming a corundum structure, and can contain an oxide containing any one of, for example, aluminum, titanium, vanadium, chromium, iron, gallium, rhodium, indium and iridium, as a main component.

More specifically, the intermediate layer is Al₂O₃, Ti₂O₃, V₂O₃, Cr₂O₃, Fe₂O₃, Ga₂O₃, Rh₂O₃, In₂O₃, and Ir₂O₃, and may be a metal oxide of a binary system represented by (AₓB₁₋ₓ)₂O₃ (0<x<1) when two elements selected from the above metallic elements are determined as A and B, or a metal oxide of a ternary system represented by (AₓB_{y}C_{1-x-y})₂O₃(0<x<1, 0<y<1) when three elements selected from the above metallic elements are determined as A, B and C.

In addition, it is also acceptable to measure the temperature of the outlet portion of the applicator 204 of the microwave irradiation portion of the supply pipe with the optical fiber thermometer 207, during film formation, and automatically adjust the output of the microwave oscillator 201 as appropriate so that the measured temperature becomes constant. In this way, the mist can be uniformly heated with less temperature unevenness.

In the present invention, annealing treatment may be performed after the film has been formed. The temperature of the annealing treatment is not particularly limited, but is preferable to be 600°C or lower, and is more preferable to be 550°C or lower. This is because the crystallinity of the film is not impaired. The treatment time of the annealing treatment is not particularly limited, but is preferable to be 10 seconds to 10 hours, and is more preferable to be 10 seconds to 1 hour.

The crystalline metal oxide film formed according to the above method may be delaminated from the base body 110. The delaminating method is not particularly limited, and may be a known method. Examples of the method include a method of delaminating by applying a mechanical impact, a method of delaminating by applying heat and utilizing the thermal stress, a method of delaminating by applying vibration such as ultrasonic waves, a method of delaminating by etching, and laser lift-off. The crystalline metal oxide film can be obtained as a self-supporting film by the delaminating.

Electrodes necessary for constituting a semiconductor device can be formed by a general method. Specifically, any of vapor deposition, sputtering, CVD, plating, and a printing method of bonding together with a resin or the like may be used. As the electrode material, any of materials may be used which include: metals such as Al, Ag, Ti, Pd, Au, Cu, Cr, Fe, W, Ta, Nb, Mn, Mo, Hf, Co, Zr, Sn, Pt, V, Ni, Ir, Zn, In and Nd; electroconductive films of metal oxides such as tin oxide, zinc oxide, indium oxide, indium tin oxide (ITO) and indium zinc oxide (IZO); and organic electroconductive compounds such as polyaniline, polythiophene and polypyrrole; and alloys or mixtures of two or more of these types may also be used. It is preferable for a thickness of the electrode to be 1 to 1000 nm, and is more preferable to be 10 to 500 nm.

### EXAMPLE

The present invention will be described in detail with reference to Examples, but the present invention is not limited thereto.

### (Example 1)

Gallium iodide was added to water, and an aqueous solution of 0.1 mol/L was prepared, and was determined as a raw material solution 104a. The raw material solution 104a obtained as described above was accommodated in a mist generating source 104. The temperature of the solution at this time was 25°C.

As a base body 110, a sapphire substrate of 4-inch and c-plane was placed on a hot plate 108 in a film forming chamber 107, and the hot plate 108 was operated to raise the temperature of the base body 110 to 500°C.

Flow-rate adjusting valves 103a and 103b were opened, nitrogen gas was supplied as the carrier gas into the film forming chamber 107 from a carrier gas source 102a (main carrier gas) and a carrier gas supply source for dilution 102b (carrier gas for dilution), and an atmosphere of the film forming chamber 107 was sufficiently replaced with the carrier gases; and the flow rate of the main carrier gas was adjusted to 12 L/min and the flow rate of the carrier gas for dilution was adjusted to 12 L/min, respectively.

Next, an ultrasonic vibrator 106 was vibrated at 2.4 MHz, and the vibration was propagated to the raw material solution 104a through water 105a, and thereby, the raw material solution 104a was misted to generate mist.

The mist was transported to the microwave heating device 200 through a supply pipe 109a by the carrier gas, and was irradiated with microwaves (2.45 GHz) in a microwave heating device 200, and the heated mist was supplied to the base body 110. At this time, the microwave irradiation portion of the supply pipe was a straight pipe made from quartz having an inner diameter of 30 mm and a wall thickness of 2 mm, and the output of the microwaves was controlled so that the temperature measured with the optical fiber thermometer was kept constant at 40°C.

Then, a film of α-Ga₂O₃ having a corundum structure was formed on the base body 110, on the condition of 500°C under the atmospheric pressure, by subjecting the mist to a thermal reaction in the film forming chamber 107, while exhausting the gas from an exhaust port 112. The film formation time was set to 1 hour. Furthermore, the raw material solution 104a in the mist generating source 104 was replenished as appropriate in the mist generating source 104 with the use of a replenishing mechanism (not illustrated) so that the height of the water surface of the raw material solution 104a duling the film formation became constant at this time.

In addition, when the flow rate of the mist and the flow rate of the carrier gas were represented by m [cm³/s] and q [cm³/s], respectively, the ratio m/q was 1/8000. Note that the flow rate m of the mist was calculated by dividing the consumption amount of the raw material solution 104a by the film formation time.

### (Comparative Example 1)

A film was formed on the same conditions as in Example 1, except that a film forming apparatus was used which did not include the microwave irradiation device 200, the mist was not irradiated with microwaves, and the film formation time was set to 2 hours, in Example 1.

### (Comparative Example 2)

A film was formed on the same conditions as in Example 1, except that the film forming apparatus was used which did not include the microwave irradiation device 200, the mist was not irradiated with the microwaves, and the whole of the supply pipe 109a was heated at a preset temperature of 40°C by a ribbon heater, in Example 1.

### (Comparative Example 3)

A film was formed on the same conditions as in Example 1, except that the film forming apparatus was used which did not include the microwave irradiation device 200, the mist was not irradiated with the microwaves, the water 105a was heated, and thereby, the raw material solution was heated to 40°C, in Example 1.

### (Example 2)

A film was formed on the same conditions as in Example 1, except that gallium acetylacetonate was dissolved as the raw material in an aqueous hydrochloric acid solution (1.0 vol%) and an aqueous solution of 0.1 mol/L was prepared and was used as the raw material solution 104a, that the flow rates of the main carrier gas and the carrier gas for dilution were adjusted to 18 L/min and 6 L/min, respectively, that a sapphire substrate of 6 inches was used as the substrate, and that the output of microwaves was controlled so that the temperature measured by the optical fiber thermometer became 50°C.

In addition, when the flow rate of the mist and the flow rate of the carrier gas were represented by m [cm³/s] and q [cm³/s], respectively, the ratio m/q was 1/5000.

### (Comparative Example 4)

A film was formed on the same conditions as in Example 2, except that, in Example 2, a film forming apparatus was used which did not include the microwave irradiation device 200 and the microwave irradiation of the mist was not performed.

### (Example 3)

A film was formed on the same conditions as in Example 1, except that gallium acetylacetonate was dissolved as the raw material in an aqueous hydrochloric acid solution (1.0 vol%) and an aqueous solution of 0.1 mol/L was prepared, then 10 vol% of formic acid was added thereto, and was used as the raw material solution 104a, that the flow rates of the main carrier gas and the diluting carrier gas were adjusted to 24 L/min and 0 L/min, respectively, that a sapphire substrate of 8 inches was used as the substrate, and that the output of microwaves was controlled so that the temperature measured by the optical fiber thermometer became 75°C.

In addition, when the flow rate of the mist and the flow rate of the carrier gas were represented by m [cm³/s] and q [cm³/s], respectively, the ratio m/q was 1/3200.

### [Evaluation 1: film thickness measurement]

Film thicknesses of the crystalline metal oxide film formed in Examples 1 to 3 and Comparative Examples 1 to 4 were each measured with the use of an optical interferometric film thickness meter F50. In addition, the film forming rate was calculated from the film thickness. The film forming rate was calculated as film thickness (µm) ÷ the film formation time (hour) = the film forming rate (µm/hour).

### [Evaluation 2: crystal structure and crystallinity evaluation]

The crystalline structure of the produced film was evaluated by XRD 2θ-ω scan. The crystalline metal oxide films formed in Examples 1 to 3 and Comparative Examples 1 to 4 were confirmed to be α-Ga₂O₃.

After that, the rocking curve of the (006) plane was measured, and the half width of the (006) plane was measured.

### [Evaluation 3: measurement of number of foreign substances and number of abnormal growth portions]

The number of foreign substances in the crystalline metal oxide films formed in Examples 1 to 3 and Comparative Examples 1 to 4 was counted in a dark visual field image at a magnification of 20 times, with the use of an optical microscope. The total field-of-view area of 0.1 to 1 cm² was observed, and the number of foreign substances (= foreign substance density) in 1 cm² was calculated. An example of the observed foreign substance is shown in FIG. 6, and an example of the abnormal growth portion is shown in FIG. 7.

The foreign substance in FIG. 6 is considered to be a deposition of a raw material, which has been formed by evaporation of the mist before the mist reaches the base body. The number of the foreign substances can be measured by an electron microscope such as SEM, a surface inspection instrument that detects a defect using difference in scattered light intensity, a surface inspection device which images with a microscope and classifies by machine learning, or the like, in addition to being capable of observing the foreign substances as bright spots in a dark visual field of a microscope as described above. In the present evaluation, foreign substances of 0.01 µm to 10 µm were counted.

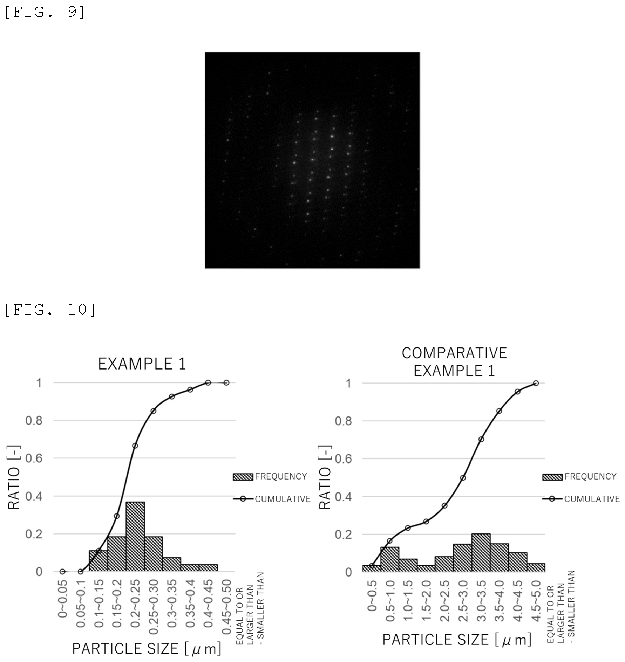

As shown in FIG. 7, the abnormal growth portion was a circular shape having a diameter of 10 to 100 µm, and a crystal other than the α phase was observed in a vicinity of the center. The cross section of the abnormal growth portion was analyzed, and as a result, a foreign substance having a size of up to several micrometers was observed in the lower portion of the abnormal growth portion, and a region which was considered to be a crystal phase existed in an upper portion of the foreign substance. Performing analysis by electron beam diffractometry, the electron beam diffraction image of the flat region outside the abnormal growth portion in FIG. 7 was an electron beam diffraction image of α-Ga₂O₃ as shown in FIG. 8, but on the other hand, the electron beam diffraction image in the region above the foreign substance, which was considered to be a crystalline phase in FIG. 7, became an electron beam diffraction image of being different from the α-Ga₂O₃ as shown in FIG. 9. This is considered to be because another crystal phase of the Ga₂O₃ (which is considered to be γ) has been formed starting from a foreign substance. Note that the conditions of the electron beam diffraction were as follows.

### Selected area electron beam diffraction method

Transmission electron microscope: manufactured by Hitachi High-Technologies Corporation H-9500
Acceleration voltage: 300 kV
Camera length: 1.0 m
Selected area: approximately 140 nm φ

The abnormal growth portion can be observed as a bright spot in a dark field image of a microscope, and the number thereof can be measured by an electron microscope such as SEM, a surface inspection instrument that detects defects by using a difference in scattered light intensity, a surface inspection device that images with a microscope and classifies by machine learning, and the like; and whether or not the abnormal growth portion is a γ phase can be determined by crystal orientation analysis such as an EBSD method.

The results of the above Evaluations 1 to 3 are summarized in Table 1.

**[Table 1]**

| # | Heating method | Heating portion | Temperature [°C] | Substrate diameter [inch] | Film forming rate [*µ*m/h] | (006) Half width [s] | Foreign substance [/cm²] | Abnormal growth [/cm²] |
|---|---|---|---|---|---|---|---|---|
| Example 1 | Microwave | Supply pipe in film forming chamber | 40 | 4 | 6.2 | 8.5 | <1 | <1 |
| Comparative Example 1 | None | - | 20 | 4 | 3 | 19.1 | 48 | 56 |
| Comparative Example 2 | Heater | Whole supply pipe | 40 | 4 | 3.6 | 28.4 | 247 | 174 |
| Comparative Example 3 | Heater | Raw material solution | 40 | 4 | 3.6 | 24.1 | 356 | 224 |
| Example 2 | Microwave | Supply pipe in film forming chamber | 50 | 6 | 5.1 | 9.4 | <1 | <1 |
| Comparative Example 4 | No heating | - | 20 | 6 | 1.8 | 26.1 | 59 | 447 |
| Example 3 | Microwave | Supply pipe in film forming chamber | 75 | 8 | 5.1 | 9.3 | <1 | <1 |

### [Evaluation 3-2: measurement of particle size distribution of foreign substance]

For the crystalline metal oxide films produced in Example 1 and Comparative Example 1, a machine learning type of surface inspection device equipped with a confocal microscope was used to detect foreign substances observed from the surface direction of the film, and the particle size of the foreign substance was measured with the use of a review function for the detected foreign substances to create a particle size distribution of the foreign substances.

The particle size here refers to a circle-equivalent diameter in a two-dimensional image observed from the surface direction of the crystalline metal oxide film. The circle-equivalent diameter is a diameter of a circle having an area equivalent to an area of a particle captured in the two-dimensional image, and the particle area can be calculated by image analysis. The same measurement can be performed, for example, with OptelicsAI² manufactured by Lasertec Corporation, etc. The results are shown in FIG. 10 and Table 2.

As shown in Table 2, the mode value of the particle size of the foreign substances in Example 1 was 0.225 µm. The particle size (D50) was 0.225 µm, at which a cumulative frequency became 50%. In addition, the standard deviation σ was 0.07 µm. In addition, a ratio (D90/D10) of the particle size (D90) at which the cumulative frequency was 90%, to the particle size (D10) at which the cumulative frequency was 10% was 2.6.

In addition, a foreign substance density was 0.4/cm², which was a ratio of the particle number of the foreign substances to the observation area. A ratio of the foreign substances having a particle size of (particle size D50 - standard deviation σ) or larger and (particle size D50 + standard deviation σ) or smaller, to the total number of the foreign substances was 75%.

In Comparative Example 1, larger particles than those in Example 1 were observed. The mode value of the particle sizes of the foreign substances was 3.25 µm. The particle size (D50) was 2.75 µm, at which the cumulative frequency became 50%. In addition, the standard deviation was 1.25 µm. In addition, a ratio (D90/D10) of the particle size (D90) at which the cumulative frequency was 90% to the particle size (D10) at which the cumulative frequency was 10% was 5.7.

The foreign substance density was 47.8/cm², which was a ratio of the particle number of the foreign substance to the observation area. A ratio of the foreign substances having a particle size of (particle size D50 - standard deviation σ) or larger and (particle size D50 + standard deviation σ) or smaller, to the total number of the foreign substances was 59%.

It is understood from the comparison between Example 1 and Comparative Example 1 that Example 1 in which the mist was irradiated with microwaves has a small amount of foreign substances and a small variation in the particle size of the foreign substances. When a semiconductor device has been manufactured with the use of the crystalline metal oxide film having a small amount of foreign substances and a small variation in the particle size of the foreign substances as in Example 1, the influence of the foreign substances on the device characteristics becomes minor.

**[Table 2]**

| | Example 1 | Comparative Example 1 |
|---|---|---|
| Mode value [*µ*m] | 0.225 | 3.25 |
| Standard deviation [*µ*m] | 0.07 | 1.25 |
| Index of particle size distribution (D90/D10) [-] | 2.6 | 5.7 |
| D10 [µm] | 0.125 | 0.75 |
| D50 [µm] | 0.225 | 2.75 |
| D90 [µm] | 0.325 | 4.25 |

### [Evaluation 4: electrical characteristics evaluation]

An SBD of a semiconductor device was produced with the use of the crystalline metal oxide films formed in Example 1 and Comparative Example 1, respectively.

The current-voltage characteristics of the obtained semiconductor device were evaluated. The voltage at which dielectric breakdown occurs was examined by measurement of the current-voltage characteristics in the reverse direction. A semiconductor device having a withstand voltage of 600 V or higher was determined as an acceptable product, and a yield was calculated according to the expression: the number of acceptable products / the total number of manufactured semiconductor devices = yield [%]. The yield of Example 1 was 97.8%, and the yield of the film of Comparative Example 1 was 42.4%.

Subsequently, for the devices manufactured in Example 1 and Comparative Example 1, the yield was calculated for each particle size of the foreign substances, for the devices in which one foreign substance was contained. The results are shown in FIG. 11. It is understood that the yield rapidly decreases when the foreign substance becomes large.

The film produced in Comparative Example 1 has a large number of foreign substances having a large size and abnormal growth portions associated therewith, and accordingly, has a large influence on the device characteristics, and the yield is as low as lower than 50%. On the other hand, the film produced in Example 1 has a small amount of foreign substances, in addition, the size of the foreign substance was small and uniform, the influence of the foreign substance on the device characteristics is small, and the yield has been as high as 95% or higher.

By comparison between Examples 1 to 3 and Comparative Examples 1 to 4, it has been confirmed that Examples 1 to 3 of the present invention adopt a film forming method of forming a crystalline metal oxide film by heat treatment of a misted raw material solution on a base body, inhibit foreign substances and abnormal portions by irradiating the mist with microwaves between the misting unit and the base body to heat the mist, and can form a film having satisfactory crystallinity at a high speed.

The present description includes the following embodiments.
[1]: A film forming apparatus comprising:
   a misting unit that mists a raw material solution to generate mist;
   a carrier gas supply unit that supplies a carrier gas for transporting the mist;
   a film forming unit that subjects the mist to heat treatment and forms a film on a base body;
   a transport unit that connects the misting unit with an inside of the film forming unit, the transport unit including a supply pipe that transports the mist by the carrier gas; and
   a microwave heating device that irradiates the mist with microwaves to heat the mist, between the misting unit and the base body.
[2]: The film forming apparatus according to the above [1], wherein the microwave heating device comprises:
   a microwave generation unit;
   a microwave irradiation unit that irradiates the mist with microwaves generated in the microwave generation unit; and
   a microwave waveguide unit through which the microwaves propagate from the microwave generation unit to the microwave irradiation unit.
[3]: The film forming apparatus according to the above [2], wherein a portion of the supply pipe arranged in the microwave irradiation unit is formed of a microwave-transmissive member.
[4]: The film forming apparatus according to the above [2] or [3], wherein the portion of the supply pipe arranged in the microwave irradiation unit is formed of any one of quartz, ceramic, alumina, a polytetrafluoroethylene resin, a copolymer resin of tetrafluoroethylene and perfluoroalkyl vinyl ether, a copolymer resin of tetrafluoroethylene and hexafluoropropylene, and a polyether ether ketone resin.
[5]: A film forming method comprising the steps of:
   generating mist by atomizing or dropletizing a raw material solution;
   transporting the mist to a film forming unit by a carrier gas;
   heating the mist with microwaves before the mist reaches a base body installed in the film forming unit; and
   forming a film on the base body by supplying the mist to the base body in the film forming unit, and subjecting the mist to heat treatment on the base body.
[6]: The film forming method according to the above [5], wherein, as the raw material solution, a solution containing a metal raw material and at least one solvent selected from water, methanol, ethanol, ethylene glycol, diethylene glycol, propylene glycol, tetraethylene glycol, glycerol, benzyl alcohol, and dipropylene glycol is used.
[7]: The film forming method according to the above [5] or [6], wherein, as the solvent of the raw material solution, a solvent containing water as a main component is used.
[8]: The film forming method according to the above [6] or [7], wherein, as the metal raw material, a material containing Ga is used.
[9]: The film forming method according to any of the above [5] to [8], wherein, as the base body, a base body having a film-forming surface with a diameter of 10 cm (4 inches) or larger is used.
[10]: The film forming method according to any of the above [5] to [9], wherein a frequency of the microwaves is set to 0.9 GHz or higher and 300 GHz or lower.
[11]: The film forming method according to any of the above [5] to [10], wherein the frequency of the microwaves is set to 2.45 GHz or higher and 25 GHz or lower.
[12]: A crystalline metal oxide film comprising at least one of gallium or aluminum as a main component, wherein
   the number density of foreign substances observed in a surface direction of the crystalline metal oxide film is less than 48/cm², and
   a standard deviation in a particle size distribution of the foreign substances is smaller than 1.25 µm.
[13]: The crystalline metal oxide film according to the above [12], wherein, in the particle size distribution of the foreign substances, an index of the particle size distribution (particle size D90 / particle size D10) is 4.0 or smaller.
[14]: The crystalline metal oxide film according to the above [12] or [13], wherein a ratio of particles having a particle size of (particle size D50 - the standard deviation) or larger and (particle size D50 + the standard deviation) or smaller, to a total number of the foreign substances, among the foreign substances, is 60% or larger.
[15]: The crystalline metal oxide film according to any of the above [12] to [14], wherein a particle size D50 of the foreign substances is smaller than 2.75 µm.
[16]: The crystalline metal oxide film according to any of the above [12] to [15], wherein a particle size D90 of the foreign substances is smaller than 4.25 µm.
[17]: The crystalline metal oxide film according to any of the above [12] to [16], wherein the crystalline metal oxide film has a corundum structure.
[18]: The crystalline metal oxide film according to any of the above [12] to [17], wherein a half width of a rocking curve of a (006) plane by X-ray diffraction of the crystalline metal oxide film is smaller than 19.1 s.
[19]: The crystalline metal oxide film according to any of the above [12] to [18], wherein a diameter of a surface of the crystalline metal oxide film is 10 cm (4 inches) or larger.
[20]: A layered structure comprising: a base body, a buffer layer on the base body, and the crystalline metal oxide film according to any of the above [12] to [19] on the buffer layer.
[21]: A semiconductor device comprising the crystalline metal oxide film according to any of the above [12] to [19], and/or the layered structure according to the above [20].
[22]: The semiconductor device according to the above [21], wherein the semiconductor device is any one of a semiconductor laser, a diode, or a transistor.

Note that the present invention is not limited to the above embodiments. The above embodiments are merely examples, and any embodiment having substantially the same configuration as the technical idea described in the claims of the present invention and exhibiting the same operation and effect is included in the technical scope of the present invention.

## Claims

1. A film forming apparatus comprising:
a misting unit that mists a raw material solution to generate mist;
a carrier gas supply unit that supplies a carrier gas for transporting the mist;
a film forming unit that subjects the mist to heat treatment and forms a film on a base body;
a transport unit that connects the misting unit with an inside of the film forming unit, the transport unit including a supply pipe that transports the mist by the carrier gas; and
a microwave heating device that irradiates the mist with microwaves to heat the mist, between the misting unit and the base body.

2. The film forming apparatus according to claim 1, wherein the microwave heating device comprises:
a microwave generation unit;
a microwave irradiation unit that irradiates the mist with microwaves generated in the microwave generation unit; and
a microwave waveguide unit through which the microwaves propagate from the microwave generation unit to the microwave irradiation unit.

3. The film forming apparatus according to claim 2, wherein a portion of the supply pipe arranged in the microwave irradiation unit is formed of a microwave-transmissive member.

4. The film forming apparatus according to claim 3, wherein the portion of the supply pipe arranged in the microwave irradiation unit is formed of any one of quartz, ceramic, alumina, a polytetrafluoroethylene resin, a copolymer resin of tetrafluoroethylene and perfluoroalkyl vinyl ether, a copolymer resin of tetrafluoroethylene and hexafluoropropylene, and a polyether ether ketone resin.

5. A film forming method comprising the steps of:
generating mist by atomizing or dropletizing a raw material solution;
transporting the mist to a film forming unit by a carrier gas;
heating the mist with microwaves before the mist reaches a base body installed in the film forming unit; and
forming a film on the base body by supplying the mist to the base body in the film forming unit, and subjecting the mist to heat treatment on the base body.

6. The film forming method according to claim 5, wherein, as the raw material solution, a solution containing a metal raw material and at least one solvent selected from water, methanol, ethanol, ethylene glycol, diethylene glycol, propylene glycol, tetraethylene glycol, glycerol, benzyl alcohol, and dipropylene glycol is used.

7. The film forming method according to claim 6, wherein, as the solvent of the raw material solution, a solvent containing water as a main component is used.

8. The film forming method according to claim 6, wherein, as the metal raw material, a material containing Ga is used.

9. The film forming method according to claim 5, wherein, as the base body, a base body having a film-forming surface with a diameter of 10 cm (4 inches) or larger is used.

10. The film forming method according to any one of claims 5 to 9, wherein a frequency of the microwaves is set to 0.9 GHz or higher and 300 GHz or lower.

11. The film forming method according to claim 10, wherein the frequency of the microwaves is set to 2.45 GHz or higher and 25 GHz or lower.

12. A crystalline metal oxide film comprising at least one of gallium or aluminum as a main component, wherein
the number density of foreign substances observed in a surface direction of the crystalline metal oxide film is less than 48/cm², and
a standard deviation in a particle size distribution of the foreign substances is smaller than 1.25 µm.

13. The crystalline metal oxide film according to claim 12, wherein, in the particle size distribution of the foreign substances, an index of the particle size distribution (particle size D90 / particle size D10) is 4.0 or smaller.

14. The crystalline metal oxide film according to claim 12, wherein a ratio of particles having a particle size of (particle size D50 - the standard deviation) or larger and (particle size D50 + the standard deviation) or smaller, to a total number of the foreign substances, among the foreign substances, is 60% or larger.

15. The crystalline metal oxide film according to claim 12, wherein a particle size D50 of the foreign substances is smaller than 2.75 µm.

16. The crystalline metal oxide film according to claim 12, wherein a particle size D90 of the foreign substances is smaller than 4.25 µm.

17. The crystalline metal oxide film according to claim 12, wherein the crystalline metal oxide film has a corundum structure.

18. The crystalline metal oxide film according to claim 12, wherein a half width of a rocking curve of a (006) plane by X-ray diffraction of the crystalline metal oxide film is smaller than 19.1 s.

19. The crystalline metal oxide film according to claim 12, wherein a diameter of a surface of the crystalline metal oxide film is 10 cm (4 inches) or larger.

20. A layered structure comprising: a base body, a buffer layer on the base body, and the crystalline metal oxide film according to claim 12 on the buffer layer.

21. A semiconductor device comprising the crystalline metal oxide film according to any one of claims 12 to 19, and/or the layered structure according to claim 20.

22. The semiconductor device according to claim 21, wherein the semiconductor device is any one of a semiconductor laser, a diode, or a transistor.
